(19) **Europäisches Patentamt European Patent Office Office européen des brevets**

(11) **EP 4 305 752 B1**

(12) **FASCICULE DE BREVET EUROPEEN**

(45) Date de publication et mention de la délivrance du brevet:
**07.05.2025 Bulletin 2025/19**

(21) Numéro de dépôt: **22712960.8**

(22) Date de dépôt: **03.03.2022**

(51) Classification Internationale des Brevets (IPC):
**H03H 9/21** *(2006.01)*    **H03H 9/215** *(2006.01)*
**H03H 3/02** *(2006.01)*    **H03H 9/02** *(2006.01)*
**G04B 17/04** *(2006.01)*    **G01C 19/5607** *(2012.01)*
**G01L 1/16** *(2006.01)*

(52) Classification Coopérative des Brevets (CPC):
**H03H 9/21; G01C 19/5607; G04B 17/045;**
**H03H 9/215;** G01L 1/162; H03H 2003/026;
H03H 2009/02291; H03H 2009/02307;
H03H 2009/0233

(86) Numéro de dépôt international:
**PCT/FR2022/050381**

(87) Numéro de publication internationale:
**WO 2022/189734 (15.09.2022 Gazette 2022/37)**

(54) **RÉSONATEUR EN VIBRATION DE FLEXION À HAUT FACTEUR DE QUALITÉ POUR LA RÉALISATION DE RÉFÉRENCES DE TEMPS, DE CAPTEURS DE FORCE OU DE GYROMÈTRES**

BIEGESCHWINGUNGSRESONATOR MIT HOHEM QUALITÄTSFAKTOR FÜR DIE HERSTELLUNG VON ZEITNORMALEN, KRAFTSENSOREN ODER GYROMETERN

FLEXURAL VIBRATION MODE RESONATOR WITH HIGH QUALITY FACTOR FOR THE REALIZATION OF TIME REFERENCES, FORCE SENSORS OR GYROMETERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.03.2021 FR 2102248**

(43) Date de publication de la demande:
**17.01.2024 Bulletin 2024/03**

(73) Titulaire: **Office National d'Etudes et de Recherches Aérospatiales 91120 Palaiseau (FR)**

(72) Inventeurs:
• **LE TRAON, Olivier**
  **91120 PALAISEAU (FR)**

• **LEVY, Raphaël**
  **91120 PALAISEAU (FR)**
• **GUERARD, Jean**
  **91120 PALAISEAU (FR)**
• **PERRIER, Thomas**
  **91120 PALAISEAU (FR)**

(74) Mandataire: **IPAZ Bâtiment Platon Parc Les Algorithmes 91190 Saint-Aubin (FR)**

(56) Documents cités:
**WO-A1-2020/212648**    **US-A1- 2001 043 026**
**US-A1- 2016 118 954**

**Description**

**Domaine technique**

La présente description concerne un résonateur à portion vibrante qui est formée dans une plaquette à faces parallèles, ainsi qu'un capteur de force et un gyromètre qui comprennent un tel résonateur.

**Technique antérieure**

Les résonateurs en vibration de flexion sont très utilisés pour réaliser des références de temps, des gyromètres et des capteurs de forces. Des exemples les plus connus sont le diapason en cristal de quartz pour fournir une référence de temps, tel que décrit par exemple dans US 3,683,213, le double diapason pour former un capteur de force, tel que décrit par exemple dans US 4,215,570, le double diapason pour mesurer une vitesse de rotation, tel que décrit par exemple aussi dans US 3,683,213, ou encore, toujours pour la mesure d'une vitesse de rotation, le simple diapason avec une structure de découplage tel que décrit par exemple dans US 6,414,416 B1.

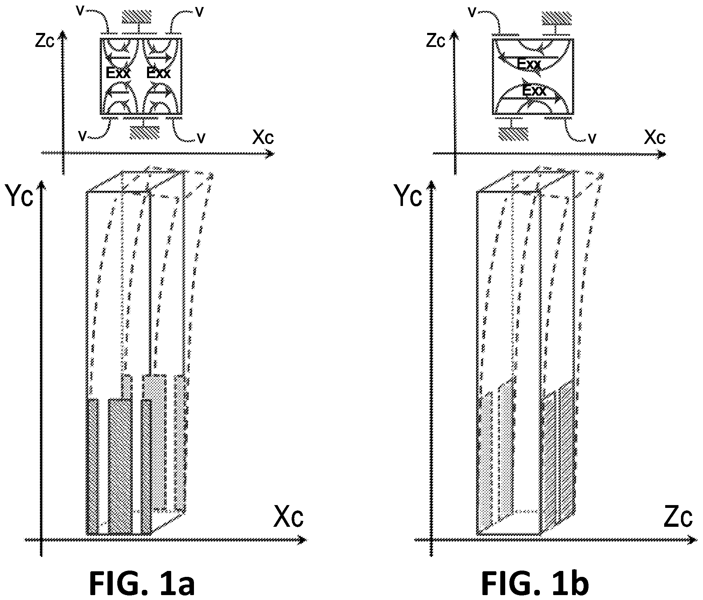

Dans le cas de résonateurs piézoélectriques en cristal de quartz qui vibrent en flexion, l'orientation de la (ou des) poutre(s) du résonateur est généralement choisie selon l'axe cristallographique Yc, et la structure plane du résonateur est parallèle au plan cristallographique Xc-Yc. Ceci permet d'une part de bénéficier de manière optimale du couplage piézoélectrique pour exciter et détecter les vibrations de flexion dans les plans Xc-Yc et Yc-Zc, et d'autre part de bénéficier de la vitesse de gravure supérieure selon l'axe Zc pour découper la structure en utilisant un procédé de gravure humide de type acide, généralement avec une mixture de fluorure d'ammonium ($NH_4F$) et d'acide fluorhydrique (HF). En effet, le tenseur piézoélectrique des cristaux de classe trigonale offre un couplage optimal pour la déformation Syy, c'est-à-dire le long de l'axe de la poutre, avec un champ électrique Exx. Pour cela, la vibration de flexion de la poutre est excitée par effet piézoélectrique direct en utilisant des électrodes qui sont situées le long de la poutre afin de générer le champ électrique Exx, et de détecter les déformations Syy via des charges électriques qui sont générées par effet piézoélectrique indirect sur ces mêmes électrodes. Plusieurs configurations alternatives sont possibles pour les électrodes. Par exemple, les électrodes peuvent être disposées sur les deux faces de la plaquette dans laquelle le résonateur est formé, comme représenté dans [Fig. 1a] pour des mouvements de vibration qui sont parallèles à la direction Xc, ou comme représenté dans [Fig. 1b] pour des mouvements de vibration hors plan qui sont parallèles la direction Zc. [Fig. 1a] et [Fig. 1b] montrent en outre pour chaque configuration d'électrodes représentée la composante Exx de champ électrique qui est utile pour produire la flexion de la poutre. De telles configurations à électrodes sur les faces de la plaquette sont simples à réaliser. Mais d'autres configurations d'électrodes sont aussi possibles, par exemple avec les électrodes disposées sur des flancs des poutres qui sont perpendiculaires aux faces de la plaquette. De telles autres configurations sont plus efficaces pour générer des flexions des poutres, mais plus difficiles à réaliser, comme décrit par exemple dans US 4,524,619.

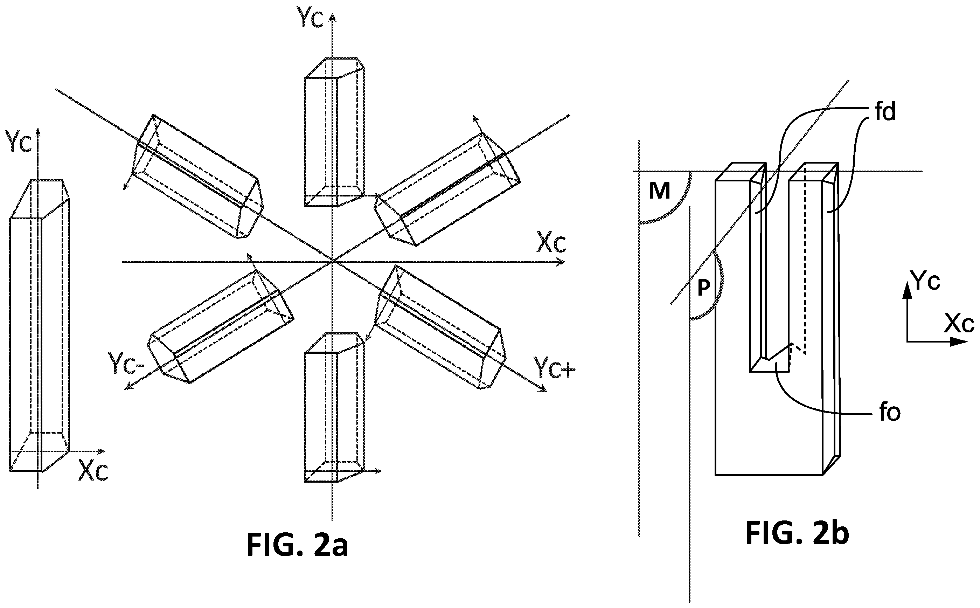

Lorsque ces résonateurs sont réalisés par gravure chimique humide d'une plaquette à faces parallèles, des facettes de gravure qui sont dues à l'orientation cristalline des plans gravés génèrent des dissymétries dans le motif du résonateur, qui altèrent son fonctionnement ultérieur. En effet, dans le cas de cristaux de symétrie trigonale de classe 32 comme le quartz, il est connu qu'une poutre d'orientation Yc qui est gravée par voie chimique en utilisant une mixture $NH_4F$-HF possède un flanc parfaitement orthogonal dans la direction Xc- et un dièdre sur le flanc orthogonal dans la direction Xc+-. Alors, du fait de la symétrie trigonale du quartz, ce motif se répète tous les 120° (degré), comme montré dans [Fig. 2a]. [Fig. 2b] montre un résultat typique qui est obtenu ainsi pour un diapason en quartz dont les faces de plaquette sont parallèles au plan Xc-Yc et les poutres orientées longitudinalement selon l'axe Yc. Les facettes fd sur les flancs des poutres du diapason rompent la symétrie par rapport au plan P qui est orthogonal aux faces de la plaquette, et les facettes fo au niveau des encastrements des poutres rompent la symétrie par rapport au plan médian M du résonateur.

Ces ruptures de symétrie provoquent un mauvais équilibrage dynamique du résonateur, ce qui génère des pertes d'énergie vibratoire dans la fixation du résonateur, et dégrade en conséquence son facteur de qualité et la stabilité de sa fréquence de vibration. Ces dégradations sont préjudiciables à l'utilisation du résonateur pour réaliser des bases de temps ou des capteurs de forces de précision.

Lorsque de tels résonateurs sont utilisés pour réaliser des gyromètres vibrants, les ruptures de symétrie du résonateur génèrent généralement un couplage mécanique parasite entre deux modes utiles de vibration du gyromètre. Il en résulte un biais de mesure, c'est-à-dire que le signal de sortie du gyromètre n'est plus nul en l'absence de rotation. L'existence d'un tel biais de mesure non-nul détériore alors grandement la précision de mesure du gyromètre.

Des moyens de compensation sont alors mis en œuvre, généralement sous forme de masses qui sont ajoutées aux extrémités des poutres et que l'on ajuste par ablation laser, pour réduite le balourd et/ou ajuster la fréquence de vibration comme décrit dans US 3,683,213, ou pour réduire le couplage en quadrature dans le cas des gyromètres vibrants décrits dans US 3,683,213.

Le couplage en quadrature pour les gyromètres provient d'un couplage mécanique qui relie deux modes utiles de vibration du gyromètre : le mode appelé «mode pilote» qui correspond généralement au mode de vibration en diapason, et le mode de vibration hors-plan appelé «mode détecteur» qui est excité par l'accélération de Coriolis à partir du mode pilote lorsque le résonateur est soumis à une rotation autour de la direction longitudinale des poutres. En présence d'une rupture de symétrie du résonateur, principalement la rupture de la symétrie par rapport au plan médian M (voir [Fig. 2b]), une raideur de couplage apparaît entre les modes pilote et détecteur, ce qui génère un mouvement parasite du résonateur dans le mode détecteur en l'absence de rotation. Un tel défaut limite fortement les performances du gyromètre en introduisant un biais de mesure. Or mettre en œuvre des ablations laser localisées et ajustées individuellement pour chaque résonateur fabriqué, afin de corriger de tels défauts de symétrie des gyromètres est particulièrement coûteux et souvent imparfait, de sorte que les performances ultimes des gyromètres restent limitées.

D'autres moyens astucieux pour réduire intrinsèquement le couplage en quadrature des gyromètres vibrants en quartz ont été mis en œuvre, comme par exemple dans FR 2 944 102 A1 au nom du demandeur. Dans FR 2 944 102 A1, l'orientation des poutres vibrantes est changée et un mode de vibration en torsion des poutres est utilisé, qui est couplé par les accélérations de Coriolis à un mode de vibration en flexion. Ces changements permettent d'obtenir une symétrie parfaite de la structure vibrante alors que le résonateur est encore réalisé en utilisant le procédé à bas coût de gravure chimique du quartz. Le couplage en quadrature a pu être réduit de cette façon de 3 à 4 ordres de grandeur, comme cela est rapporté par Guérard et al. dans l'article intitulé «Quartz structures for Coriolis Vibrating Gyroscopes», DOI : 10.1109/ISISS.2014.6782534, mais au détriment de la sensibilité thermique intrinsèque du gyromètre, très dégradée à cause de la dépendance thermique importante du mode de torsion, due aux propriétés intrinsèques du quartz.

US 2006/0201248 A1 propose une structure originale de gyromètre vibrant en quartz, dans laquelle l'axe sensible est perpendiculaire au plan de la structure, en tirant partie de la symétrie trigonale du quartz et en utilisant trois poutres qui sont orientées selon les axes cristallographiques Yc. De cette façon, le gyromètre obtenu bénéficie d'un très bon couplage piézoélectrique entre les modes pilote et détecteur. Mais une telle structure vibrante n'est pas symétrique par rapport au plan qui est orthogonal à celui de la plaquette lorsqu'elle est découpée par gravure chimique, et les modes de vibration mis-en-jeu ne permettent pas d'obtenir un bon équilibrage dynamique du résonateur. Les coefficients de qualité des modes de vibration utiles sont alors dégradés.

Pour les capteurs de forces, la structure à double diapason qui est décrite dans US 4,215,570 constitue un compromis intéressant, notamment grâce à la fente très fine qui sépare les deux poutres destinées à vibrer en opposition de phase. Cette configuration assure un bon couplage entre les résonateurs tout en réduisant la déformation des zones d'encastrement des poutres. De cette façon, un mouvement longitudinal parasite qui apparaît lorsque les poutres vibrent, et qui est cause de dissipation d'énergie, est réduit. Ce mouvement longitudinal est par exemple exploité dans les diapasons de musique, pour transmettre les vibrations des poutres à un support résonant à travers le pied du diapason, afin d'émettre un son audible bien pratique pour accorder des instruments de musique. Cet exemple d'exploitation du mouvement longitudinal qui est transmis par le pied du diapason montre bien la fuite d'énergie qui se produit du résonateur vers l'extérieur, à travers son pied. D'autre part, le double diapason de US 4,215,570, lorsqu'il est réalisé par gravure chimique, ne présente pas non plus de symétrie par rapport à un plan orthogonal à celui du résonateur, à cause du dièdre qui est présent sur le flanc orthogonal dans la direction Xc+. Cette dissymétrie géométrique génère aussi une dissymétrie dans la transmission des efforts longitudinaux dans les deux poutres, rendant inégales les variations de fréquence des deux poutres qui constituent le diapason. Cela peut alors ruiner l'effet diapason, et réduire fortement la valeur de facteur de qualité qui est effective lorsque le résonateur est soumis à une force axiale de traction à mesurer. Des alternatives au double diapason ont été proposées pour réaliser des capteurs de forces, comme celle décrite dans FR 2 574 209 A1 au nom du demandeur. FR 2 574 209 A1 propose en effet d'associer un simple résonateur à poutre unique qui est destinée à vibrer en flexion avec des systèmes de découplage des vibrations de cette poutre vis-à-vis du support, via des masses d'inertie qui sont ménagées aux extrémités de la poutre. Ce résonateur a deux avantages : d'une part une seule lame au lieu de deux pour le diapason permet de doubler le facteur d'échelle du résonateur, c'est-à-dire la variation de fréquence en fonction de force axiale de traction à mesurer, et d'autre part le principe de découplage qui est très tolérant vis-à-vis d'erreurs d'alignement qui peuvent exister. Mais un tel résonateur reste encombrant, ce qui peut limiter son utilisation dans des dispositifs miniatures tels que les accéléromètres basés sur un résonateur utilisé comme élément sensible, et sur la variation de fréquence qui est associée à la force générée par une masse d'épreuve via l'accélération à mesurer. Une autre alternative originale a été proposée dans FR 2 739 190 A1 aussi au nom du demandeur, en intégrant au sein d'une structure monolithique d'accéléromètre un simple résonateur en flexion et en ménageant au niveau de la structure monolithique d'accéléromètre un système de découplage des vibrations vis-à-vis de l'extérieur. Une optimisation du simple résonateur en vibration de flexion a aussi été proposée dans FR 2 805 344 A1 encore au nom du demandeur, en améliorant la valeur du facteur de mérite F x Q /Sf, où F est la fréquence du résonateur, Q est le facteur de qualité de la résonance, et Sf est le facteur d'échelle exprimé en Hertz par m/s$^2$. Cette amélioration est obtenue en utilisant une poutre à section non-constante qui procure un gain d'un facteur 1,2 sur le facteur de mérite F x Q /Sf, représentatif de la stabilité du biais de l'accéléromètre, c'est-à-dire la stabilité de la fréquence du résonateur en l'absence d'accélération. Cependant, ces simples résonateurs ne répondent pas aux applications de capteurs de forces à fréquence variable qui nécessitent que le résonateur soit intrinsèquement découplé et insensible à ses conditions de fixation pour permettre une mesure aisée et fiable de la force. A partir de là, un aspect de la présente invention est de proposer un nouveau capteur de force qui réponde à ces impératifs de découplage intrinsèque, mais non plus basé sur la modification de raideur de la poutre vibrant en flexion, telle que produite par la force axiale agissant comme un couple de rappel et modifiant ainsi la fréquence de résonance, mais en modifiant l'inertie de flexion qui est générée par le déplacement produit par la force appliquée au résonateur. Ce principe de capteur de force basé sur une modification d'inertie de flexion a déjà été proposé, par exemple dans l'article «New resonant accelerometer based on rigidity change», Y. Omura, Y. Nonomura, O. Tabata, TRANSDUCERS 97, 1997, Internationnal Conf. Solid-State Sensors and Actuators, Chicago, mais sur la base d'un résonateur non-découplé, ce qui ne peut pas satisfaire des applications exigeantes où un résonateur à valeur élevée de facteur de qualité est nécessaire pour la résolution et la précision de mesure.

Il est important de rappeler à ce stade que la gravure chimique par voie humide pour réaliser des dispositifs vibrants cristallins est un procédé peu coûteux et particulièrement adapté pour une production collective de micro-dispositifs, tout en préservant les coefficients de qualité intrinsèque du cristal. En effet, la gravure chimique, en étant basée sur une réaction chimique locale, permet de dissoudre le cristal atome par atome sans altérer ni dégrader le réseau cristallin du matériau. Tel n'est pas le cas pour des gravures qui sont basées sur une abrasion locale, comme l'usinage ultrasonore qui utilise des grains abrasifs excités par des ondes ultrasonores générées entre une sonde (sonotrode) et la surface à graver, ou basées sur un bombardement ionique qui utilise l'énergie cinétique d'ions. Ces deux dernières techniques altèrent le réseau cristallin en périphérie de la gravure, sur des distances caractéristiques de quelques dizaines de nanomètres à quelques micromètres pour les gravures les plus énergétiques, ce qui réduit le coefficient de qualité intrinsèque des résonateurs, et ce d'autant plus qu'une miniaturisation du dispositif est recherchée.

## Problème technique

A partir de cette situation, un but de la présente invention est de fournir un nouveau résonateur qui soit amélioré par rapport à certains au moins des inconvénients des résonateurs antérieurs, tels que rappelés ci-dessus.

Notamment, un but de l'invention est de fournir un résonateur pour lequel les pertes d'énergie de vibration vers l'extérieur sont réduites, afin de procurer une valeur de facteur de qualité qui est accrue.

Un but annexe de l'invention est de réduire les défauts de symétrie qui peuvent affecter la forme du résonateur, en provenant d'écarts de vitesse de gravure qui existent entre des orientations cristallines différentes d'un matériau utilisé pour constituer le résonateur.

## Résumé de l'invention

Pour atteindre l'un au moins de ces buts ou un autre, un premier aspect de l'invention propose un résonateur qui comprend :

- une portion d'une plaquette à deux faces opposées qui sont planes et parallèles, la portion de plaquette étant destinée à vibrer par flexion lors d'une utilisation du résonateur, et appelée portion vibrante ; et
- une partie de support, qui est externe à la portion vibrante et connectée à celle-ci par un segment intermédiaire de la plaquette, appelé pied, ce pied étant continu de matériau avec la portion vibrante et formant une liaison rigide entre la partie de support et la portion vibrante.

Dans ce résonateur de l'invention, la portion vibrante possède un premier plan de symétrie, appelé plan médian, qui est parallèle aux deux faces de la plaquette et équidistant avec ces deux faces, et un second plan de symétrie, appelé plan de symétrie orthogonal à la plaquette, qui est perpendiculaire au plan médian et passe longitudinalement par la liaison que forme le pied entre la partie de support et la portion vibrante. L'intersection entre le plan médian et le plan de symétrie orthogonal à la plaquette constitue un axe médian de la portion vibrante.
La portion vibrante comprend deux extensions qui sont destinées chacune à vibrer par flexion, ces deux extensions s'étendant à partir du pied symétriquement de chaque côté du plan de symétrie orthogonal à la plaquette.

Selon des caractéristiques de l'invention, chaque extension est pourvue d'une fente longitudinale qui traverse la portion vibrante perpendiculairement au plan médian, à partir du plan de symétrie orthogonal à la plaquette en direction d'une extrémité distale de cette extension, mais sans atteindre cette extrémité distale, de sorte que chaque extension soit formée par un méandre. Les fentes respectives des deux extensions sont symétriques par rapport au plan de symétrie orthogonal à la plaquette, et se rejoignent au niveau de ce plan de symétrie orthogonal à la plaquette. Ainsi, la portion vibrante comprend deux segments primaires qui relient chacun le pied à l'extrémité distale de l'une des extensions, et deux segments secondaires qui sont reliés l'un à l'autre au niveau du plan de symétrie orthogonal à la plaquette par des extrémités proximales respectives de ces segments secondaires, et qui s'étendent chacun jusqu'à l'extrémité distale de l'une des extensions pour être connectée à l'un des segments primaires au niveau de cette extrémité distale.

Grâce à une telle configuration de la portion vibrante, et pour un mode de vibration de la partie vibrante qui ne comporte que des déplacements parallèles au plan médian, et qui est symétrique par rapport au plan de symétrie orthogonal à la plaquette, les deux segments primaires ont des composantes de vitesse instantanées, parallèles à l'axe médian, qui ont un sens opposé à chaque instant pendant la vibration, à celui des composantes de vitesse instantanées des segments secondaires, aussi parallèles à l'axe médian. Ces orientations de vitesse opposées permettent à des composantes de quantité de mouvement qui leur sont associées de se compenser au moins partiellement, si bien que des déplacements qui sont transmis au pied par la portion vibrante sont réduits. Il en résulte que le résonateur possède des pertes d'énergie de vibration qui sont faibles, si bien que son facteur de qualité peut être élevé.

Avantageusement, la portion vibrante peut présenter une répartition de masse telle que le mode de vibration qui ne comporte que des déplacements parallèles au plan médian et qui est symétrique par rapport au plan de symétrie orthogonal à la plaquette, ne provoque pas de déplacement du pied parallèlement à l'axe médian. Autrement dit, la compensation des composantes de quantité de mouvement de la portion vibrante, qui sont parallèles à l'axe médian du résonateur, peut être exacte ou quasi-exacte. Dans ce cas, les pertes d'énergie de vibration par le pied du résonateur sont nulles ou quasi-nulles, et le facteur de qualité peut être très élevé.

Dans des modes préférés de réalisation de l'invention, le matériau de la plaquette peut être monocristallin de classe trigonale et piézoélectrique. Dans ce cas, l'axe médian de la portion vibrante est parallèle à un axe Xc du matériau, et les deux segments primaires ainsi que les deux segments secondaires de la portion vibrante sont parallèles à des axes Yc du matériau. Autrement dit, l'une des deux extensions de la portion vibrante peut être parallèle à l'axe cristallographique Yc+ et l'autre parallèle à l'axe cristallographique Yc-. Pour de tels modes de réalisation, les deux extensions de la portion vibrante peuvent former entre elles un angle qui est égal à 60°. En particulier, la plaquette peut être en cristal de quartz $\alpha$ ($\alpha$-SiO$_2$) ou tout autre cristal du système trigonal de classe de symétrie 32, comme l'orthophosphate de gallium (GaPO$_4$), l'oxyde de germanium (GeO$_2$), l'arséniate de gallium (GaAsO$_4$), ou encore les cristaux de la famille des LGX : la langasite (LGS ou La$_3$Ga$_5$Si0$_{14}$), le langatate (LGT ou La$_3$Ga$_5$,5TaO,5O$_{14}$) ou la langanite (LGN ou La$_3$Ga$_5$,5NbO,5O$_{14}$).

Alternativement, les deux extensions de la portion vibrante peuvent former entre elles un angle qui est égal à 180°.

Lorsque le matériau de la plaquette est monocristallin de classe trigonale et piézoélectrique, le résonateur de l'invention peut comprendre en outre :

- des moyens d'excitation, adaptés pour générer des déformations par flexion de la portion vibrante, ces moyens d'excitation comprenant une première et une seconde électrode qui sont isolées électriquement l'une de l'autre, la première électrode comprenant, sur chaque face de la plaquette et pour chaque segment primaire ou secondaire, un ruban de matériau conducteur électriquement qui est disposé longitudinalement sur ce segment, centralement dans une largeur du segment, et la seconde électrode comprenant, aussi sur chaque face de la plaquette et pour chaque segment primaire ou secondaire, deux rubans sur ce segment qui sont disposés sur deux côtés opposés du ruban de la première électrode ; et
- des moyens de détection, adaptés pour mesurer une amplitude des déformations de flexion de la partie vibrante qui sont générées par les moyens d'excitation lors d'une utilisation du résonateur, ces moyens de détection comprenant un circuit de détection d'un courant électrique qui apparaît dans les première et seconde électrodes.

De façon générale pour l'invention, chaque extension de la portion vibrante peut comporter, au niveau de son extrémité distale et parallèlement au plan médian, un élargissement par rapport à des bords longitudinaux externes des segments primaire et secondaire de cette extension. De tels élargissements procurent un degré de liberté supplémentaire pour réaliser la compensation des composantes de quantité de mouvement de la portion vibrante qui sont parallèles à l'axe médian. Ainsi, la conception d'un résonateur conforme à l'invention, et qui possède un facteur de qualité élevé, est facilitée.

Aussi de façon générale pour l'invention, le résonateur peut comprendre en outre une portion supplémentaire de la plaquette, en forme de segment et appelée pédoncule, qui s'étend à partir des extrémités proximales des segments secondaires reliées l'une à l'autre, parallèlement à l'axe médian et dans une direction opposée au pied. Ce pédoncule peut aussi participer à obtenir la compensation des composantes de quantité de mouvement de la portion vibrante qui sont parallèles à l'axe médian.

Possiblement, le résonateur peut comprendre deux portions vibrantes qui sont formées dans la même plaquette, et munies de pédoncules respectifs. Les deux portions vibrantes peuvent alors être reliées l'une à l'autre par leurs pédoncules, en étant orientées de façon opposée l'une par rapport à l'autre de sorte que les axes médians respectifs des deux portions vibrantes soient superposés.

Selon une autre possibilité, le résonateur peut encore comprendre deux portions vibrantes qui sont formées dans la même plaquette, en étant reliées l'une à l'autre par les pieds respectifs de ces deux portions vibrantes, et orientées de façon opposée l'une par rapport à l'autre de sorte que les axes médians respectifs des deux portions vibrantes soient encore superposés.

Un second aspect de l'invention propose un capteur de force, qui comprend un résonateur conforme à l'invention, à deux portions vibrantes reliées l'une à l'autre par leurs pédoncules respectifs. Un tel capteur est adapté pour mesurer une force de traction qui est appliquée entre les pieds respectifs des deux portions vibrantes, et qui est parallèle aux axes médians des deux portions vibrantes.

Enfin, un troisième aspect de l'invention concerne un gyromètre qui comprend au moins un résonateur conforme au premier aspect de l'invention. Le fonctionnement d'un tel gyromètre utilise le couplage qui est produit par les accélérations de Coriolis entre le mode de vibration aux déplacements qui sont parallèles au plan médian et un mode de vibration pour lequel les déplacements sont perpendiculaires à ce plan médian.

De préférence, le gyromètre peut comporter un résonateur à deux portions vibrantes qui sont reliées l'une à l'autre par leurs pieds respectifs en étant orientées selon des directions opposées. Pour une telle configuration du gyromètre, deux utilisations distinctes sont possibles, chacune à un seul axe sensible de rotation, en fonction du mode pilote qui est choisi. Selon un premier choix possible pour le mode pilote, les deux portions vibrantes vibrent en opposition de phase dans ce mode pilote. Les accélérations de Coriolis qui sont générées par une rotation d'axe parallèle à l'axe médian commun des deux portions vibrantes excitent alors un mode de vibration hors-plan qui est équilibré dynamiquement. Selon un autre choix qui est aussi possible, les deux portions vibrantes vibrent cette fois en phase dans le mode pilote, et les accélérations de Coriolis qui sont générées par une rotation autour d'un axe qui est perpendiculaire à l'axe médian commun des deux portions vibrantes et qui est parallèle au plan médian, excitent un autre mode de vibration hors-plan lui aussi équilibré dynamiquement. Dans une réalisation préférée d'un tel gyromètre à deux portions vibrantes qui sont reliées par leurs pieds respectifs en étant orientées à l'opposé l'une de l'autre, la plaquette peut être en cristal de quartz et chacune des deux portions vibrantes a ses extensions à 60° l'une de l'autre et parallèles à des axes cristallographiques Yc. Une telle configuration permet d'obtenir un couplage piézoélectrique optimal pour les modes de vibration à exciter ou détecter, ainsi qu'une réalisation symétrique du résonateur lorsqu'il est fabriqué par gravure chimique.

**Brève description des figures**

Les caractéristiques et avantages de la présente invention apparaîtront plus clairement dans la description détaillée ci-après d'exemples de réalisation non-limitatifs, en référence aux figures annexées parmi lesquelles :

[Fig. 1a], déjà commentée, est un rappel sur une première configuration possible d'électrodes, adaptée pour le couplage piézoélectrique qui peut être utilisé pour l'excitation et la détection de vibrations de flexion d'une poutre dans le plan, dans le cas d'un matériau de la poutre qui est piézoélectrique et appartient au système trigonal et de classe de symétrie 32, comme le quartz $\alpha$ ;

[Fig. 1b], déjà commentée, correspond à [Fig. 1a] pour une seconde configuration possible d'électrodes qui peut être utilisée pour l'excitation et la détection de vibrations hors plan ;

[Fig. 2a], déjà commentée, est un rappel sur la symétrie trigonale ;

[Fig. 2b], déjà commentée, montre un résonateur en forme de diapason tel que connu de l'art antérieur et obtenu par gravure chimique d'un cristal de quartz, en utilisant une mixture de fluorure d'ammonium et d'acide fluorhydrique, avec les ruptures de symétrie qui en résultent lorsque les deux poutres du diapason sont parallèles à l'axe Y ;

[Fig. 3a] montre des quantités de mouvement qui sont mises en jeu pour un diapason à poutres parallèles tel que connu de l'art antérieur ;

[Fig. 3b] correspond à [Fig. 3a] pour un diapason à poutres non-parallèles ;

[Fig. 3c] correspond à [Fig. 3b] pour un double diapason à branches non-parallèles, permettant de compenser globalement des quantités de mouvement qui ne sont pas équilibrées au sein de chaque diapason ;

[Fig. 4a] est une vue en plan d'un premier résonateur en matériau piézoélectrique trigonal, qui est conforme à l'invention ;

[Fig. 4b] correspond à [Fig. 4a] pour montrer des déformations du mode de vibration utile du premier résonateur, et des quantités de mouvement associées ;

[Fig. 4c] correspond à [Fig. 4a] pour montrer des électrodes de celui-ci permettant d'exciter et de détecter la vibration du mode utile, dans le cas d'un cristal piézoélectrique trigonal et de classe de symétrie 32, comme le quartz, qui constitue le résonateur ;

[Fig. 4d] est une vue en coupe du premier résonateur, correspondant à [Fig. 4c] ;

[Fig. 5a] correspond à [Fig. 4a] lorsque deux perfectionnements possibles de l'invention sont utilisés ;

[Fig. 5b] correspond à [Fig. 5a] pour montrer des déformations du mode de vibration utile ;

[Fig. 6a] est une vue en plan d'un deuxième résonateur en matériau piézoélectrique, qui est aussi conforme à l'invention ;

[Fig. 6b] correspond à [Fig. 6a] pour montrer des déformations du mode de vibration utile du deuxième résonateur ;

[Fig. 6c] correspond à [Fig. 6a], lorsque qu'un perfectionnement possible de l'invention est utilisé ;

[Fig. 6d] correspond à [Fig. 6b] pour le résonateur de [Fig. 6c] ;

[Fig. 7a] est une vue en perspective d'un premier gyromètre qui est conforme à l'invention, et montre des déformations qui sont associées à un mode pilote de ce premier gyromètre ;

[Fig. 7b] correspond à [Fig. 7a] mais en montrant des déformations qui sont générées à partir du mode pilote de [Fig. 7a] par une rotation autour d'un premier axe, ;

[Fig. 7c] correspond à [Fig. 7b] pour un deuxième axe de rotation ;

[Fig. 7d] correspond à [Fig. 7b] pour un troisième axe de rotation ;

[Fig. 8a] montre des déformations d'un second gyromètre aussi conforme à l'invention, qui sont générées dans un premier mode pilote ;

[Fig. 8b] correspond à [Fig. 8a] pour montrer des déformations d'un premier mode détecteur du second gyromètre, qui sont générées par une rotation autour d'un premier axe à partir du premier mode pilote ;

[Fig. 8c] montre d'autres déformations du second gyromètre, qui sont générées dans un second mode pilote ;

[Fig. 8d] correspond à [Fig. 8b], pour montrer des déformations d'un second mode détecteur du second gyromètre, qui sont générées par une rotation autour d'un second axe à partir du second mode pilote ;

[Fig. 9a] est une vue en perspective du second gyromètre, qui montre des électrodes de celui-ci ;

[Fig. 9b] est une première vue en coupe du second gyromètre, correspondant à [Fig. 9a] ;

[Fig. 9c] est une seconde vue en coupe du second gyromètre, correspondant aussi à [Fig. 9a] ;

[Fig. 10a] est une vue en plan d'un premier capteur de force qui est conforme à l'invention ;

[Fig. 10b] correspond à [Fig. 10a] en montrant des déformations associées à un mode de vibration utile du premier capteur de force ;

[Fig. 10c] correspond à [Fig. 10a] en montrant une déformation statique du premier capteur de force lorsqu'il est soumis à une force de traction axiale ;

[Fig. 11a] correspond à [Fig. 10a] pour un second capteur de force qui est aussi conforme à l'invention ;

[Fig. 11b] correspond à [Fig. 10b] pour le second capteur de force ; et

[Fig. 11c] correspond à [Fig. 10c] pour le second capteur de force.

**Description détaillée de l'invention**

Pour raison de clarté, les dimensions des éléments qui sont représentés dans ces figures ne correspondent ni à des dimensions réelles, ni à des rapports de dimensions réels. Notamment, toutes les déformations de résonateurs qui sont représentées sont exagérément agrandies pour les rendre visibles. En outre, des références identiques qui sont indiquées dans des figures différentes désignent des éléments ou des mesures identiques, ou qui ont des fonctions identiques.

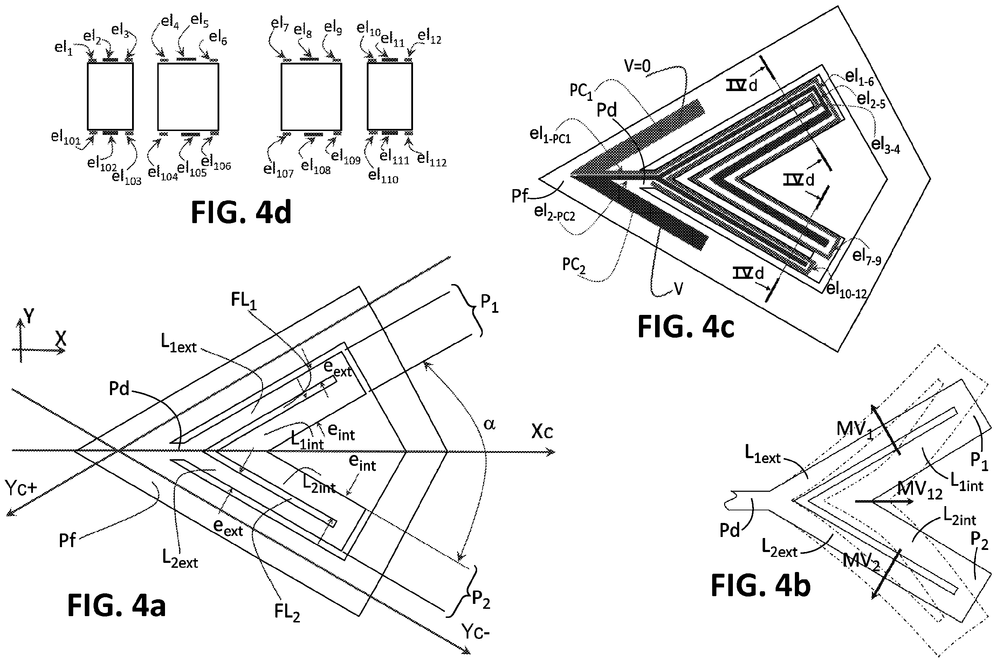

Un premier résonateur conforme à l'invention est décrit maintenant en référence à [Fig. 4a]-[Fig. 4d]. Ce premier résonateur comprend une partie de support, ou partie fixe désignée par la référence Pf, une portion vibrante, et un pied Pd qui relie la portion vibrante à la partie fixe Pf. De préférence, la partie fixe Pf, la portion vibrante et le pied Pd sont formés simultanément dans une plaquette à faces parallèles par gravure chimique, de sorte que ces trois parties de résonateur sont continues de matériau. La plaquette utilisée peut avoir une épaisseur comprise entre quelques micromètres et quelques millimètres, lorsque cette épaisseur est mesurée perpendiculairement à ses faces. La portion vibrante du résonateur de [Fig. 4a]-[Fig. 4d] comprend deux extensions $P_1$ et $P_2$ qui s'étendent à partir du pied Pd et qui forment entre elles un angle $\alpha$ non-nul. Les deux extensions $P_1$ et $P_2$ s'étendent symétriquement de part et d'autre d'un axe médian qui coïncide avec une direction longitudinale du pied Pd. Cet axe médian correspond à l'intersection entre un premier plan de symétrie qui est parallèle aux faces de la plaquette et situé à mi-épaisseur de celle-ci, et un second plan de symétrie qui est orthogonal aux faces de la plaquette et pour lequel les deux extensions $P_1$ et $P_2$ se correspondent par symétrie-miroir. Dans la suite de cette description, et par analogie avec un résonateur en diapason tel que décrit dans US 3,683,213, les deux extensions $P_1$ et $P_2$ sont aussi appelées poutres $P_1$ et $P_2$. Selon l'invention, une fente longitudinale est ménagée sur chaque poutre $P_1$, $P_2$, et désignée par la référence $FL_1$, $FL_2$ respectivement. Ces deux fentes longitudinales $FL_1$ et $FL_2$ se rejoignent au niveau de l'axe médian du résonateur. Chaque poutre $P_i$, l'indice i étant égal à 1 ou 2, est ainsi constituée de deux lames $L_{iext}$ et $L_{iint}$. Dans la partie générale de la présente description, la lame $L_{1ext}$ (respectivement $L_{2ext}$) a été appelée segment primaire de l'extension $P_1$ (resp. $P_2$), et la lame $L_{1int}$ (respectivement $L_{2int}$) a été appelée segment secondaire de l'extension $P_1$ (resp. $P_2$). Ainsi, les deux lames $L_{1ext}$ et $L_{2ext}$ sont reliées au pied Pd, et s'étendent jusqu'à des extrémités distales respectives des extensions $P_1$ et $P_2$, où elles sont reliées une-à-une aux deux lames $L_{1int}$ et $L_{2int}$. Ainsi, chaque extension $P_1$, $P_2$ forme un méandre entre l'axe médian et son extrémité distale. En outre, les lames $L_{1int}$ et $L_{2int}$ sont reliées entre elles au niveau de l'axe médian, par des extrémités proximales respectives de ces deux lames $L_{1int}$ et $L_{2int}$. Les deux fentes longitudinales $FL_1$ et $FL_2$ des poutres $P_1$ et $P_2$, respectivement, se rejoignent aussi au niveau de l'axe médian, de sorte la jonction des extrémités proximales respectives des deux lames $L_{1int}$ et $L_{2int}$ est séparée des lames $L_{1ext}$ et $L_{2ext}$ et du pied Pd. Comme cela est montré dans [Fig. 4b], lorsque, au cours d'une vibration du résonateur, les extrémités distales des poutres $P_1$ et $P_2$ s'écartent symétriquement de l'axe médian dans des sens opposés, les lames $L_{1ext}$ et $L_{2ext}$ ont des quantités de mouvement respectives, $MV_1$ et $MV_2$, qui sont orientées vers le même côté du résonateur que le pied Pd, obliquement mais symétriquement, et la jonction commune des lames $L_{1int}$ et $L_{2int}$ possède une quantité de mouvement $MV_{12}$ qui est parallèle à l'axe médian en étant orientée à l'opposé du pied Pd. Il en résulte que les lames $L_{1int}$ et $L_{2int}$ possèdent des quantités de mouvement respectives qui sont orientées vers le côté du résonateur qui est opposé au pied Pd, obliquement mais symétriquement. Alors, selon une optimisation proposée par l'invention, une répartition de masse dans la portion vibrante entre toutes les lames $L_{1ext}$, $L_{2ext}$, $L_{1int}$ et $L_{2int}$ peut être telle qu'un déplacement du pied Pd qui résulte de ces quantités de mouvement soit nul ou quasi-nul. Grâce à une telle absence de déplacement du pied Pd, la transmission d'énergie de vibration de la part de la portion vibrante à la partie de support Pf est nulle ou très faible, si bien que le facteur de qualité du résonateur peut être élevé. La répartition de masse optimisée entre les quatre lames de la partie vibrante est encore symétrique par rapport à l'axe médian, et peut être obtenue en attribuant une épaisseur commune $e_{ext}$ aux deux lames $L_{1ext}$ et $L_{2ext}$ qui est différente de celle des deux lames $L_{1int}$ et $L_{2int}$, notée $e_{int}$. Lorsqu'une telle optimisation est appliquée, le résonateur est dit équilibré. Les épaisseurs de lames $e_{ext}$ et $e_{int}$ sont mesurées parallèlement aux faces de la plaquette.

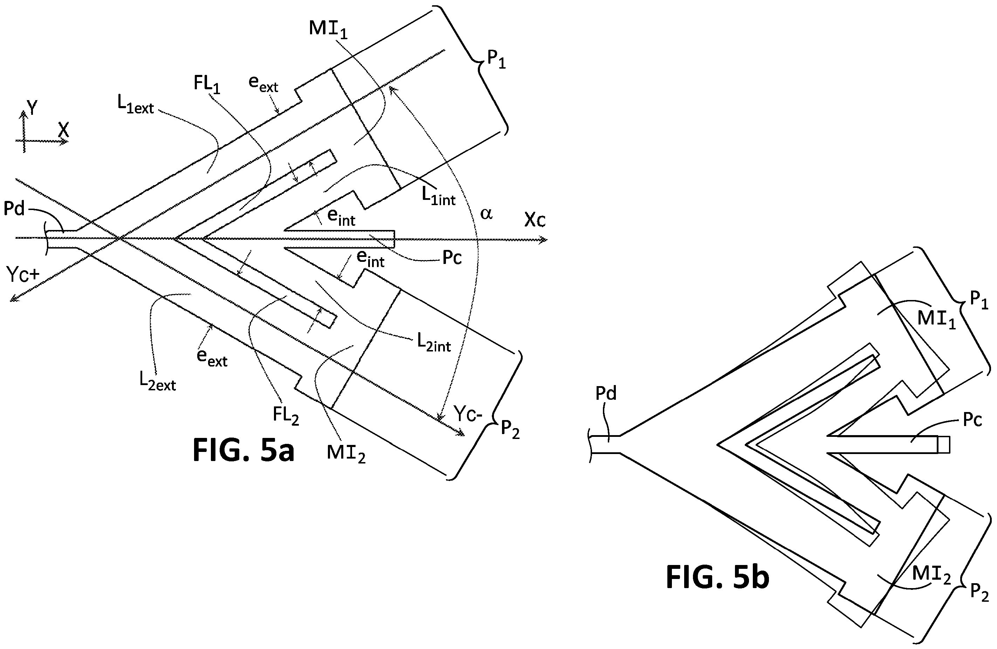

Selon deux perfectionnements de l'invention qui sont montrés ensemble dans [Fig. 5a] mais qui peuvent être utilisés indépendamment l'un de l'autre, la partie vibrante du résonateur peut être complétée par deux masses d'inertie $MI_1$ et $MI_2$ pour le premier perfectionnement, et par un pédoncule Pc pour le second perfectionnement. De préférence, les deux masses d'inertie $MI_1$ et $MI_2$ sont situées aux extrémités distales des deux poutres $P_1$ et $P_2$, et sont identiques. Elles peuvent être formées chacune par un élargissement de la poutre correspondante $P_1$, $P_2$ au niveau de son extrémité distale. Le pédoncule Pc peut être formé par une lame additionnelle qui s'étend à partir de la jonction des extrémités proximales des lames $L_{1int}$ et $L_{2int}$, parallèlement à l'axe médian et en superposition avec lui, dans un sens qui est opposé au pied Pd. Avantageusement, le pédoncule Pc est aussi symétrique par rapport à l'axe médian. L'ajout des deux masses d'inertie $MI_1$ et $MI_2$, et/ou celui du pédoncule Pc, à la portion vibrante du résonateur permet d'obtenir l'équilibrage de celui-ci avec des degrés de liberté supplémentaires. [Fig. 5b] montre les déplacements des masses d'inertie $MI_1$ et $MI_2$ ainsi que celui du pédoncule Pc à un même instant pendant la vibration du résonateur. Les deux masses d'inertie $MI_1$ et $MI_2$ ont alors des composantes de quantités de mouvement selon l'axe médian qui sont opposées à celle du pédoncule Pc. Ces composantes de quantités de mouvement des masses d'inertie $MI_1$ et $MI_2$ et du pédoncule Pc se combinent avec celles

des quatre lames $L_{1ext}$, $L_{2ext}$, $L_{1int}$ et $L_{2int}$ pour produire le déplacement du pied Pd, qui est nul ou sensiblement nul en appliquant l'invention.

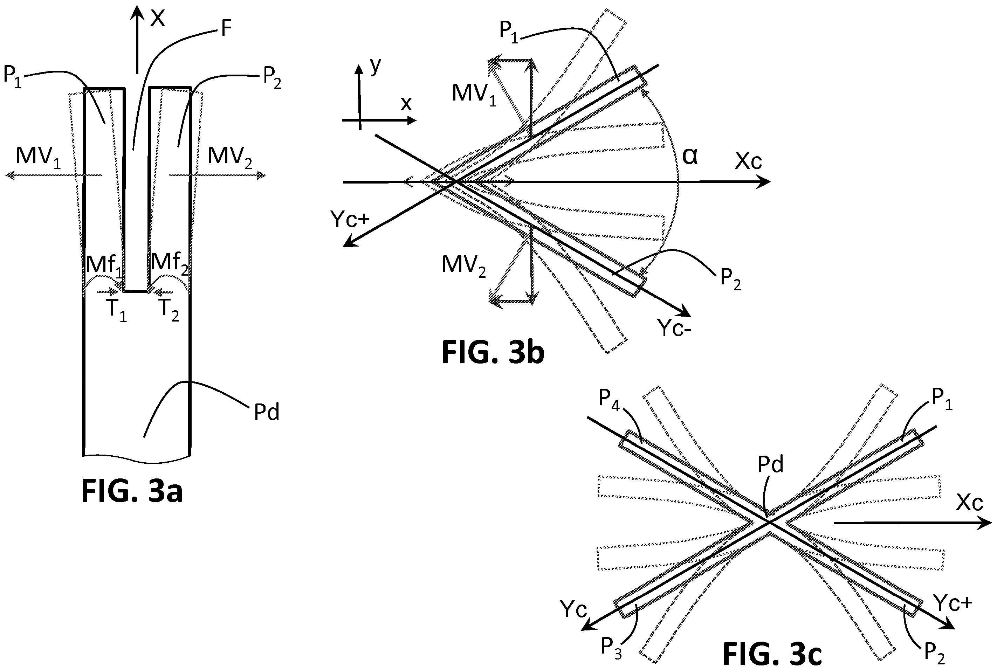

Il est à noter qu'un tel équilibrage de résonateur est naturellement obtenu pour un diapason à poutres parallèles tel que connu de l'art antérieur et représenté dans [Fig. 3a], dès lors que les deux poutres $P_1$ et $P_2$ sont identiques. Les quantités de mouvement des deux poutres $P_1$ et $P_2$ sont encore référencées $MV_1$ et $MV_2$, respectivement. Un tel résonateur conforme à [Fig. 3a] ne provoque pas de déplacement de son pied Pd parallèlement à son axe médian X pendant ses vibrations, car les quantités de mouvement $MV_1$ et $MV_2$ sont perpendiculaires à cet axe médian. De plus, pour le mode de vibration où les deux poutres $P_1$ et $P_2$ se déplacent en opposition de phase, les quantités de mouvement $MV_1$ et $MV_2$ des deux poutres s'équilibrent si les deux poutres $P_1$ et $P_2$ sont identiques. Le résonateur en diapason est alors équilibré. Il n'y a donc pas de transmission d'énergie vibratoire par les poutres $P_1$ et $P_2$ au pied Pd, en négligeant les déformations de ce pied au niveau des encastrements des deux poutres $P_1$ et $P_2$, que produisent les moments fléchissants $Mf_1$ et $Mf_2$ et les efforts tranchants $T_1$ et $T_2$, ce qui est d'autant plus vrai que l'écart de séparation entre les deux poutres $P_1$ et $P_2$ est étroit. Toutefois, comme cela a été mentionné plus haut, un tel résonateur à poutres parallèles et symétriques ne peut pas être réalisé uniquement par gravure chimique d'une plaquette en matériau cristallin trigonal de classe 32, à cause de facettes de gravure qui apparaissent et rompent la symétrie de forme entre les deux poutres $P_1$ et $P_2$. Pour obtenir deux poutres qui ont des formes symétriques, il est possible de réaliser le résonateur avec ses deux poutres $P_1$ et $P_2$ qui sont parallèles aux axes Yc+ et Yc- du matériau cristallin trigonal de classe 32, et avec l'axe médian du résonateur qui est parallèle à l'axe cristallographique Xc. Mais alors les deux poutres $P_1$ et $P_2$ du diapason ne sont plus parallèles, et il devient impossible d'équilibrer le résonateur pour cette raison. Grâce à l'utilisation des fentes longitudinales $FL_1$ et $FL_2$ selon l'invention, dans le résonateur de [Fig. 4a]-[Fig. 4d], l'équilibrage du résonateur est de nouveau possible bien que ses poutres $P_1$ et $P_2$ ne soient pas parallèles l'une à l'autre.

Les inventeurs indiquent qu'il est toutefois possible d'équilibrer le résonateur de [Fig. 3b] à poutres non-parallèles en symétrisant sa portion vibrante par rapport au plan Y-Z. La portion vibrante comporte ainsi quatre poutres $P_1$, $P_2$, $P_3$ et $P_4$ qui peuvent avoir des formes symétriques telles que résultant de la gravure chimique d'un matériau cristallin trigonal de classe 32. Le pied Pd du résonateur est alors situé à la jonction des quatre poutres. Dans ce cas, le résonateur est équilibré pour un mode de vibration dans lequel les deux diapasons vibrent en phase. Toutefois, la configuration de résonateur à double diapason qui est ainsi obtenue, telle que représentée dans [Fig. 3c], est plus encombrante et peut être mal adaptée à des applications où une miniaturisation importante est nécessaire. Pour de telles applications, le résonateur de [Fig. 4a]-[Fig. 4d] ou [Fig. 5a]-[Fig. 5b] peut être préféré.

Pour le résonateur de [Fig. 4a]-[Fig. 4d] ou [Fig. 5a]-[Fig. 5b], l'angle $\alpha$ entre les deux poutres $P_1$ et $P_2$ est égal à 60°. De cette façon, il est possible d'en obtenir des réalisations symétriques par gravure chimique d'une plaquette à faces parallèles qui est constituée d'un matériau cristallin trigonal de classe 32, en orientant longitudinalement les poutres $P_1$ et $P_2$ parallèlement aux axes cristallographiques Yc+ et Yc-, et l'axe médian parallèlement à l'axe cristallographique Xc, les faces de la plaquette étant perpendiculaires à l'axe Z. Par exemple, le matériau de la plaquette peut être du quartz $\alpha$ monocristallin, qui est piézoélectrique. Dans ce cas, le résonateur peut être pourvu de deux électrodes telles que représentées dans [Fig. 4c] et [Fig. 4d]. De façon connue, ces électrodes peuvent servir à la fois de moyens d'excitation du mode de vibration symétrique, et de moyen de détection de l'amplitude de vibration dans ce même mode. Les références qui sont dans ces deux figures ont les significations mentionnées ci-dessous :

pour la première électrode, qui peut être connectée à une masse électrique :

$PC_1$ segment de la première électrode qui est porté par la partie de support Pf du résonateur

$el_{1-PC1}$ segment de la première électrode qui est porté par le pied Pd du résonateur

$el_1$ segment de la première électrode qui est porté par la lame $L_{1ext}$ le long d'un bord externe de celle-ci, sur une première des deux faces de la plaquette

$el_3$ segment de la première électrode qui est porté par la lame $L_{1ext}$ le long d'un bord interne de celle-ci, sur la première face de la plaquette

$el_4$ segment de la première électrode qui est porté par la lame $L_{1int}$ le long d'un bord interne de celle-ci, sur la première face de la plaquette

$el_6$ segment de la première électrode qui est porté par la lame $L_{1int}$ le long d'un bord externe de celle-ci, sur la première face de la plaquette

$el_7$ et $el_9$ correspondent à $el_6$ et $el_4$, respectivement, pour la lame $L_{2int}$

$el_{10}$ et $el_{12}$ correspondent à $el_3$ et $el_1$, respectivement, pour la lame $L_{2ext}$

$el_{1-6}$ segment de raccordement électrique entre les segments $el_1$ et $el_6$ au niveau de l'extrémité distale de la poutre $P_1$, sur la première face de la plaquette

$el_{3-4}$ segment de raccordement électrique entre les segments $el_3$ et $el_4$ au niveau de l'extrémité distale de la poutre $P_1$, sur la première face de la plaquette

$el_{7-9}$ segment de raccordement électrique entre les segments $el_7$ et $el_9$ au niveau de l'extrémité distale de la

poutre $P_2$, sur la première face de la plaquette

$el_{10\text{-}12}$ segment de raccordement électrique entre les segments $el_{10}$ et $el_{12}$ au niveau de l'extrémité distale de la poutre $P_2$ et sur la première face de la plaquette.

Les segments de première électrode $el_6$ et $el_7$ sont connectés l'un à l'autre au niveau de l'axe médian, de même que les segments $el_4$ et $el_9$, et de même que les segments $el_3$ et $el_{10}$.

pour la seconde électrode, qui peut être connectée à une source de potentiel électrique alternatif V :

$PC_2$ et $el_{2\text{-}PC2}$ correspondent à $PC_1$ et $el_{1\text{-}PC1}$, respectivement, et pour la seconde électrode

$el_2$ segment de la seconde électrode qui est porté par la lame $L_{1ext}$ dans une partie centrale de celle-ci, sur la première face de la plaquette

els, els et $el_{11}$ correspondent à $el_2$ pour les lames $L_{1int}$, $L_{2int}$ et $L_{2ext}$, respectivement

$el_{2\text{-}5}$ segment de raccordement électrique entre les segments $el_2$ et $el_5$ au niveau de l'extrémité distale de la poutre $P_1$, sur la première face de la plaquette.

Les segments de seconde électrode $el_5$ et $el_8$ sont connectés l'un à l'autre au niveau de l'axe médian, de même que les segments $el_2$ et $el_{11}$.

Les segments d'électrodes $el_{10n}$, pour l'indice entier n variant de 1 à 12, correspondent respectivement aux segments $el_n$ pour la seconde face de la plaquette, avec des segments de raccordement électrique qui sont analogues à ceux décrits pour la première face de la plaquette. Enfin, les segments d'une même des deux électrodes qui sont situés sur l'une et l'autre des deux faces de la plaquette sont reliés électriquement entre eux, soit par une connexion électrique portée par le résonateur, soit par une connexion électrique externe.

Chaque segment d'électrode peut être constitué par un ruban de matériau conducteur tel que l'or (Au), par exemple déposé en utilisant une technique de formation de couches minces, et avoir une largeur égale à 200 $\mu$m (micromètre). Conformément à l'énumération qui vient d'être fournie, trois rubans parallèles sont disposés sur chaque face de lame, soit un total de douze rubans conducteurs par face de la plaquette, $el_1$ à $el_{12}$ sur la première face et $el_{101}$ à $el_{112}$ sur la seconde face. Comme déjà expliqué en référence à la [Fig. 1a], les trois rubans conducteurs sur chaque face de lame permettent une excitation et une détection qui sont efficaces pour des vibrations de flexion de la lame parallèles au plan Xc-Yc, lorsque cette lame s'étend longitudinalement selon l'axe cristallographique Yc+ ou Yc-. Pour une efficacité accrue du couplage piézoélectrique, il est avantageux que les rubans de la première électrode soient relativement fins, avec des largeurs de ruban qui sont comprises entre 1/10 et 1/5 de l'épaisseur $e_{ext}$ ou eint des lames $L_{1ext}$, $L_{2ext}$, $L_{1int}$ et $L_{2int}$. Pour les rubans de la seconde électrode, leurs largeurs peuvent être comprises entre deux et cinq fois celles des rubans de la première électrode.

Un tel schéma d'électrodes d'excitation et de détection des vibrations par effet piézoélectrique est adapté pour le mode de vibration de flexion où les deux poutres $P_1$ et $P_2$ se déplacent en opposition de phase, comme représenté sur [Fig. 4b]. Toutefois, d'autres configurations d'électrodes sont possibles alternativement, par exemple en déposant des rubans de matériau conducteur sur les flancs des lames qui sont perpendiculaires aux faces de la plaquette. Dans ce cas, les rubans $el_1$ et $el_{101}$ sont remplacés par un ruban unique sur le flanc de la lame $L_{1ext}$, et pareillement pour les paires de rubans de la première électrode qui sont portés séparément par les autres lames $L_{1int}$, $L_{2int}$ et $L_{2ext}$. Chaque flanc de lame porte alors deux rubans qui sont chacun proche d'un bord du flanc opposé à celui de l'autre ruban, avec l'un des deux rubans qui appartient à la première électrode, et l'autre ruban qui appartient à la seconde électrode. Cette autre configuration d'électrodes est plus efficace que celle de [Fig. 4c]-[Fig. 4d] pour le couplage piézoélectrique, mais au prix d'une plus grande complexité de réalisation.

Le résonateur peut ainsi être associé à une boucle électronique oscillante, qui est connectée en entrée aux segments $PC_1$ de la première électrode sur la partie de support Pf du résonateur, et en sortie aux segments $PC_2$ de la seconde électrode aussi sur la partie de support Pf. Le mode de vibration pour lequel les deux poutres $P_1$ et $P_2$ se déplacent en opposition de phase est ainsi excité par la tension alternative V qui est appliquée par la boucle électronique oscillante entre les deux électrodes, et l'amplitude de vibration du résonateur pour ce même mode est détectée par le courant électrique qui est généré par les vibrations du résonateur dans les deux électrodes. Pour cela, un circuit de détection de courant peut être utilisé dans la boucle électronique oscillante, qui possède avantageusement une impédance d'entrée élevée.

Les inventeurs fournissent à présent quelques règles qui permettent d'équilibrer selon l'invention un résonateur conforme à [Fig. 4a]-[Fig. 4d], c'est-à-dire sans les masses d'inertie $MI_1$, $MI_2$ ni le pédoncule Pc. La fréquence F du résonateur pour le mode de vibration de flexion considéré, où les deux poutres $P_1$ et $P_2$ se déplacent symétriquement en opposition de phase, peut être approchée en utilisant l'équation suivante (équation 1) :

$$F(\text{en Hertz}) \cong 0.58 \cdot \frac{\dfrac{e_{int}}{L_{int}^2} \cdot \dfrac{e_{ext}}{L_{ext}^2}}{\dfrac{e_{int}^2}{L_{int}^4} + \dfrac{e_{ext}^2}{L_{ext}^4}} \cdot \frac{e_{int} \cdot \sqrt{\dfrac{e_{int} + F_l}{e_{ext} + F_l}}}{L_{int} \cdot L_{ext}} \cdot \sqrt{\dfrac{E}{\rho}}$$

avec les significations suivantes, déjà données pour certaines d'entre elles :

$e_{int}$ : épaisseur commune des lames $L_{1int}$ et $L_{2int}$, mesurée parallèlement aux faces de la plaquette et exprimée en mètre

$e_{ext}$ : épaisseur commune des lames $L_{1ext}$ et $L_{2ext}$, mesurée parallèlement aux faces de la plaquette et exprimée en mètre

$L_{int}$ : longueur commune des lames $L_{1int}$ et $L_{2int}$, exprimée en mètre

$L_{ext}$ : longueur commune des lames $L_{1ext}$ et $L_{2ext}$, exprimée en mètre

$F_l$ : largeur commune des fentes longitudinales $FL_1$ et $FL_2$ dans les extensions $P_1$ et $P_2$, mesurée parallèlement aux faces de la plaquette et exprimée en mètre

$E$ : module d'Young du matériau de la plaquette, exprimé en newton par mètre-carré ($N/m^2$)

$\rho$ : masse volumique du matériau de la plaquette, exprimé en kilogrammes par mètre-cube ($kg/m^3$).

Pour permettre la compensation au niveau du pied Pd des composantes de quantités de mouvement parallèles à l'axe Xc, il faut de plus que les dimensions $e_{int}$, $e_{ext}$, $L_{int}$ et $L_{ext}$ vérifient la condition suivante (équation 2) :

$$\left(\frac{e_{ext}}{e_{int}}\right)^{0,5} \cdot \frac{\left(\dfrac{L_{ext}}{e_{ext}}\right)^3 - \left(\dfrac{L_{int}}{e_{int}}\right)^3}{\left(\dfrac{L_{ext}}{e_{ext}}\right)^3 + \left(\dfrac{L_{int}}{e_{int}}\right)^3} \cong 0,64$$

Or cette condition signifie que l'élancement $L_{ext}/e_{ext}$ de chaque lame $L_{1ext}$, $L_{2ext}$ est supérieur à l'élancement $L_{int}/e_{int}$ de chaque lame $L_{1int}$, $L_{2int}$. L'équation 2 peut aussi être écrite sous la forme suivante (équation 3) :

$$\frac{L_{ext}}{L_{int}} = \frac{e_{ext}}{e_{int}} \cdot \left(\frac{1+k}{1-k}\right)^{1/3} \text{ avec } k = 0,64 \cdot \left(\frac{e_{int}}{e_{ext}}\right)^{1/2}$$

La positivité de 1-k permet de donner une première borne pour le quotient $e_{ext}/e_{int}$ : ce quotient est supérieur à 0,4. De plus, par construction, l'équation suivante relie les longueurs de lames $L_{ext}$ et $L_{int}$, par l'intermédiaire de l'angle $\alpha$ qui sépare les deux poutres $P_1$ et $P_2$ (équation 4) :

$$L_{ext} = L_{int} + \frac{2 \cdot F_l + e_{int} + e_{ext}}{2 \cdot \tan\left(\frac{\alpha}{2}\right)}$$

Les trois dernières équations, aux cinq inconnues $e_{ext}$, $e_{int}$, $L_{ext}$, $L_{int}$ et $F_l$, permettent à l'Homme du métier de choisir les dimensions du résonateur en fonction des applications visées et des contraintes technologiques, notamment en fonction l'encombrement qui est disponible pour le résonateur dans chaque application.

A titre d'exemple, avec une plaquette en cristal du système trigonal de classe de symétrie 32, comme le quartz $\alpha$ qui est piézoélectrique, et pour un angle $\alpha$ de 60° entre les deux poutres $P_1$ et $P_2$, chacune orientée parallèlement à un axe cristallographique Yc, l'une parallèle à Yc+ et l'autre à Yc-, pour garantir la symétrie du résonateur tel qu'obtenu par gravure chimique comme déjà expliqué, il est possible de dimensionner un résonateur équilibré avec un élancement $P_{int}=L_{int}/e_{int}$ commun aux lames $L_{1int}$ et $L_{2int}$, qui est compris entre 3 et 10, et un autre élancement $P_{ext}=L_{ext}/e_{ext}$ commun aux lames $L_{1ext}$ et $L_{2ext}$, qui est compris entre 8 et 30, et avec un quotient $e_{int}/e_{ext}$ qui est compris entre 1 et 5. Par exemple, $L_{int}$~2,5 mm (millimètre), $e_{int}$~0,24 mm, $L_{ext}$~3,3 mm, $e_{ext}$~0,15 mm et $F_l$~0,27 mm, produisant une fréquence de vibration F du résonateur qui est égale à 32 kHz (kilohertz). Cette même valeur de 32 kHz pour la fréquence F peut aussi être obtenue avec $L_{int}$~4,95 mm, $e_{int}$~1,5 mm, $L_{ext}$~8,9 mm, $e_{ext}$~1,7 mm et $F_l$~0,7 mm, ce qui montre l'étendue des possibilités de dimensionnement pour obtenir un résonateur équilibré en utilisant l'invention.

Pour les résonateurs destinés à vibrer en flexion, le coefficient de qualité intrinsèque du résonateur est limité par les pertes thermoélastiques qui sont générées par échange de chaleur entre des fibres comprimées et tendues de chaque lame pendant la vibration, comme cela a été théorisé dans l'article de C. Zener, intitulé «Internal friction in solids», Physical Review 52, August 1937, pp.230-235. Dans le cas du quartz et pour une simple poutre en vibration de flexion à une fréquence qui est comprise entre quelques kilohertz et quelques centaines de kilohertz, le coefficient de qualité thermoélastique est proportionnel à la fréquence F du résonateur multipliée par l'épaisseur vibrante e au carré : $Q_{thermoélastique}$(quartz) $\propto$ F.$e^2$. Dans le cas du silicium et pour le même intervalle de fréquence, ce coefficient thermoélastique est proportionnel à la fréquence F du résonateur divisée par l'épaisseur vibrante e au carré : $Q_{thermoélastique}$ (silicium) $\propto$ F/$e^2$, ce qui conduit à des dimensionnements des résonateurs qui sont très différents entre ces deux cristaux. Ainsi, dans le cas du quartz et quand des performances de stabilité de la fréquence du résonateur sont recherchées, des dimensionnements qui correspondent à des valeurs importantes pour les épaisseurs $e_{int}$ et $e_{ext}$ sont privilégiés, et inversement pour le silicium.

Par rapport à une configuration du résonateur conforme à [Fig. 4a], l'ajout du pédondule Pc modifie la quantité de mouvement qui est générée selon l'axe Xc par la vibration : une composante de quantité de mouvement du pédoncule Pc s'ajoute à celles des lames $L_{1int}$ et $L_{2int}$. Elle permet ainsi d'augmenter les possibilités de dimensionnement qui produisent un équilibrage du résonateur. Notamment, l'ajout du pédoncule Pc permet d'augmenter l'épaisseur $e_{ext}$ des lames $L_{1ext}$ et $L_{2ext}$ par rapport à la configuration sans pédoncule de [Fig. 4a].

Encore par rapport à une configuration du résonateur conforme à [Fig. 4a], l'ajout des masses d'inertie $MI_1$ et $MI_2$ aux extrémités distales des poutres $P_1$ et $P_2$ permet aussi de modifier la répartition de quantité de mouvement entre toutes les parties de la portion vibrante. Notamment, l'ajout des masses d'inertie $MI_1$ et $MI_2$ permet d'augmenter l'épaisseur $e_{int}$ des lames $L_{1int}$ et $L_{2int}$ à valeur égale de la longueur $L_{int}$ de celles-ci.

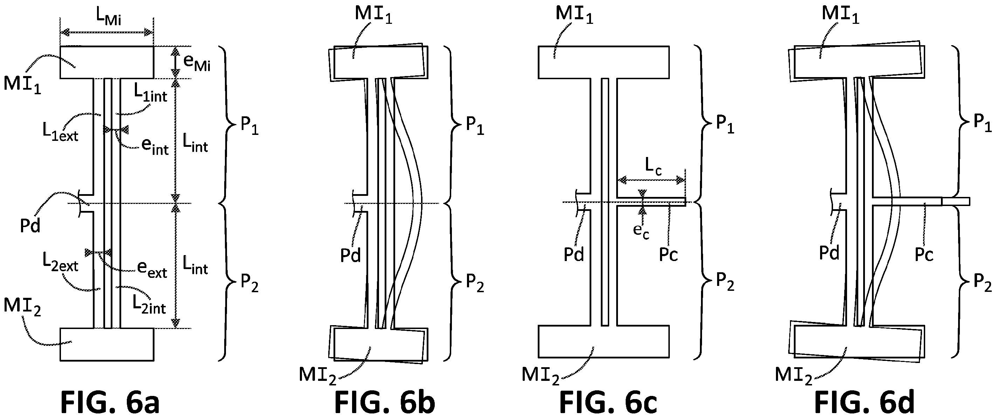

Le résonateur de [Fig. 6a] ou [Fig. 6c] correspond à celui de [Fig. 5a] mais avec l'angle $\alpha$ qui est égal à 180° au lieu de 60°, sans pédoncule pour [Fig. 6a] et avec pédoncule Pc pour [Fig. 6c]. Les longueurs de lames $L_{ext}$ et $L_{int}$ deviennent alors égales, et la condition de l'équation 3 pour l'équilibrage du résonateur, fournie précédemment pour un résonateur sans le pédoncule Pc ni les masses d'inertie $MI_1$ et $MI_2$, ne peut plus être satisfaite. Les masses d'inertie $MI_1$ et $MI_2$ sont nécessaires lorsque l'angle $\alpha$ est égal à 180°, pour obtenir la compensation des quantités de mouvement. Le mode de vibration qui est représenté sur [Fig. 6b] lorsque le résonateur est dépourvu de pédoncule, ou sur [Fig. 6d] lorsque le résonateur comporte le pédoncule Pc, correspond principalement à une vibration de flexion de la lame continue qui est la réunion des deux lames précédentes $L_{1int}$ et $L_{2int}$, avec une longueur totale égale à la somme de leurs longueurs individuelles, et avec encore l'épaisseur $e_{int}$. La fréquence F du résonateur pour ce mode de vibration peut être approchée par l'équation suivante (équation 5) :

$$F(\text{en Hertz}) \cong \frac{e_{int}}{L_{int}^2} \cdot \left( \frac{L_{int} \cdot e_{int}}{L_c \cdot e_c + L_{int} \cdot e_{int}} \right)^{3/4} \cdot \sqrt{\frac{E}{\rho}}$$

avec :

$L_{int}$ : longueur totale de lame mesurée entre les deux masses d'inertie $MI_1$ et $MI_2$, et exprimée en mètre

$e_{int}$ : largeur de la lame qui est opposée au pied Pd, mesurée parallèlement aux faces de la plaquette et exprimée en mètre

$L_c$ : longueur du pédoncule Pc, mesurée parallèlement aux faces de la plaquette et exprimée en mètre

$e_c$ : largeur du pédoncule Pc, mesurée parallèlement aux faces de la plaquette et exprimée en mètre.

E : module d'Young du matériau de la plaquette, exprimé en newton par mètre-carré (N/$m^2$)

$\rho$ : masse volumique du matériau de la plaquette, exprimé en kilogrammes par mètre-cube (kg/$m^3$).

Pour permettre la compensation des quantités de mouvement selon l'axe Xc, il faut en plus que les dimensions $e_{int}$, $e_{ext}$, $L_{int}$, $e_{Mi}$, $L_{Mi}$, $L_c$ et $e_c$ respectent la double inégalité suivante (équation 6) :

$$1 \leq \frac{\sqrt{J}}{(L_{int} \cdot e_{int} + L_c \cdot e_c)} \cdot \frac{e_{int}}{e_{ext}} \cdot \sqrt{\frac{e_{int} + e_{ext}}{L_{int}}} \leq 3{,}5$$

avec en plus les significations suivantes :

$e_{ext}$ : largeur de la lame qui est connectée pied Pd, mesurée parallèlement aux faces de la plaquette et exprimée en mètre

$e_{Mi}$ : largeur commune des masses d'inertie MI$_1$ et MI$_2$, mesurée parallèlement aux lames et exprimée en mètre

$L_{Mi}$ : longueur commune des masses d'inertie MI$_1$ et MI$_2$, mesurée parallèlement à l'axe Xc et exprimée en mètre

J : moment d'inertie par unité de masse surfacique des masses d'inertie MI$_1$ et MI$_2$, qui est égal à (équation 7) :

$$J = L_{Mi} \cdot e_{Mi} \cdot \left(L_{Mi}{}^2 + e_{Mi}{}^2\right)$$

La double inégalité de l'équation 6 permet de dimensionner les résonateurs de [Fig. 6a]-[Fig. 6d] pour qu'ils soient équilibrés, à partir de certaines valeurs qui sont choisies initialement en fonction de caractéristiques recherchées pour ces résonateurs.

Eventuellement, le dimensionnement de chacun des résonateurs qui ont été présentés ci-dessus, en utilisant les règles fournies précédemment, pourra être poursuivi à l'aide de simulations numériques telles que des calculs par éléments finis, pour parvenir à des équilibrages plus précis de ces résonateurs.

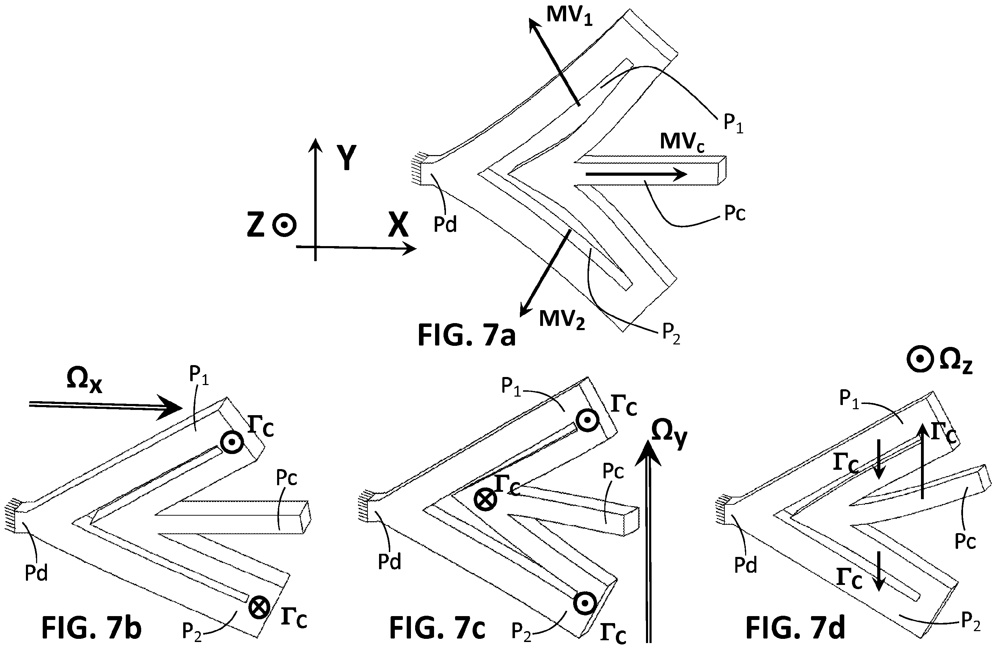

Un résonateur tel que décrit précédemment peut être utilisé pour constituer un gyromètre à un ou plusieurs axes sensibles. On appelle axe sensible du gyromètre un axe de rotation pour lequel le gyromètre permet de mesurer vitesse de rotation autour de cet axe. Pour obtenir un gyromètre à trois axes sensibles, permettant de mesurer des composantes de vitesse de rotation respectivement selon les axes X, Y et Z, un résonateur pour lequel l'angle α est différent de 0° et de 180° est nécessaire. Un tel résonateur pour lequel l'angle α est égal à 60° est préféré. L'accélération de Coriolis produit, lors de la rotation du résonateur, un déplacement additionnel de chaque lame du résonateur qui est perpendiculaire au déplacement de cette lame pour le mode pilote. [Fig. 7a] rappelle les déplacements simultanés des poutres P$_1$ et P$_2$, ainsi que du pédoncule Pc, pour un résonateur conforme à l'invention avec α égal à 60°, et lorsque le mode de vibration qui est excité par les électrodes, c'est-à-dire le mode pilote, est celui où les deux poutres P$_1$ et P$_2$ se déplacent en opposition de phase parallèlement aux faces de la plaquette, à la façon d'un diapason. MV$_1$, MV$_2$ et MV$_c$ désignent les quantités de mouvement respectives des poutres P$_1$, P$_2$ et du pédoncule Pc. [Fig. 7b] montre les accélérations de Coriolis correspondantes, notées Γ$_C$, qui sont produites par une rotation autour de l'axe X, avec une vitesse de rotation Ω$_x$, [Fig. 7c] montre celles qui sont produites par une rotation autour de l'axe Y, avec une vitesse de rotation Ω$_y$, et [Fig. 7d] montre celles qui sont produites par une rotation autour de l'axe Z, avec une vitesse de rotation Ω$_z$. Ces accélérations de Coriolis sont perpendiculaires à la plaquette pour les rotations autour des axes X et Y, avec le symbole du point entouré d'un cercle pour représenter une accélération de Coriolis qui est dirigée vers le lecteur, et une croix entourée d'un cercle pour représenter une accélération de Coriolis qui est dirigée selon la direction de regard du lecteur. Toutefois, les forces d'inertie qui résultent de ces accélérations de Coriolis ne sont pas équilibrées au niveau du pied Pd, de sorte qu'il est préférable de prévoir des moyens additionnels pour limiter les pertes d'énergie de vibration qui se produisent à travers le pied Pd du résonateur. Par exemple, une structure de découplage telle que décrite dans US 6,414,416 B1 au nom du demandeur, pourrait être utilisée pour un gyromètre à un seul axe sensible qui serait l'axe X (cf. [Fig. 7b]), puisque cette structure de découplage est efficace pour réduire ou éviter une transmission de mouvements de torsion à la partie de fixation du résonateur par son pied Pd. Pour un gyromètre à un seul axe sensible qui serait l'axe Y (cf. [Fig. 7c]), le mode de vibration qui est couplé au mode pilote de [Fig. 7a] par la vitesse de rotation Ω$_y$ est un mode où les deux poutres P$_1$ et P$_2$ subissent une flexion en phase hors-plan, et le pédoncule Pc subit une flexion hors-plan qui est en opposition de phase par rapport aux poutres P$_1$ et P$_2$. Mais les forces qui en résultent ne s'équilibrent pas au niveau du pied Pd du résonateur, et un moment résiduel est transmis à la partie de fixation du résonateur par son pied Pd. Les forces qui sont générées lors d'une rotation autour de l'axe Z (cf. [Fig. 7d]) à partir du mode pilote de [Fig. 7a] sont parallèles à la plaquette, mais ne s'équilibrent pas non plus.

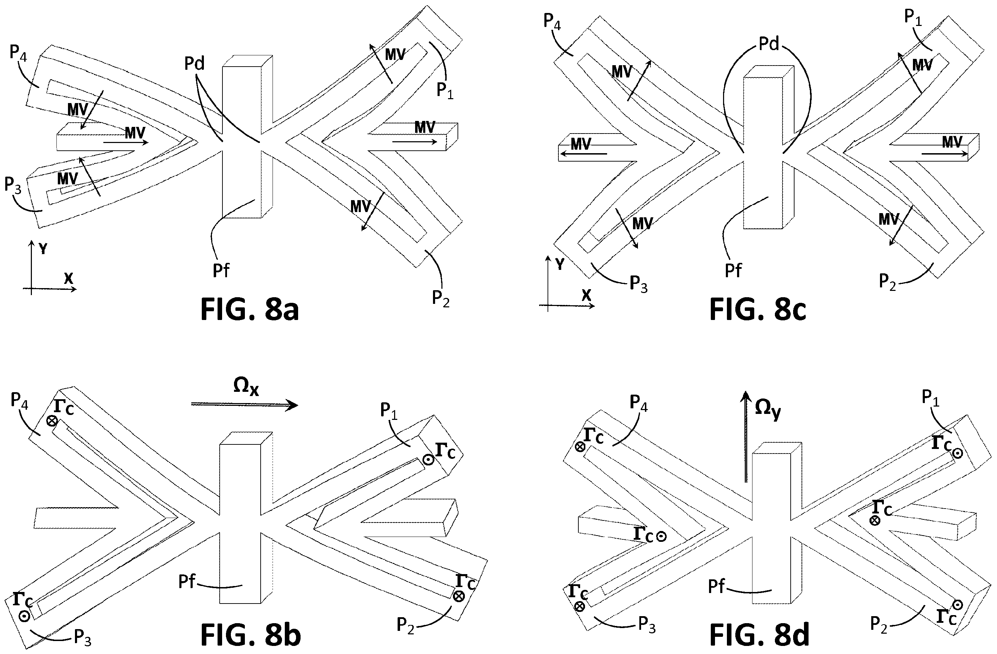

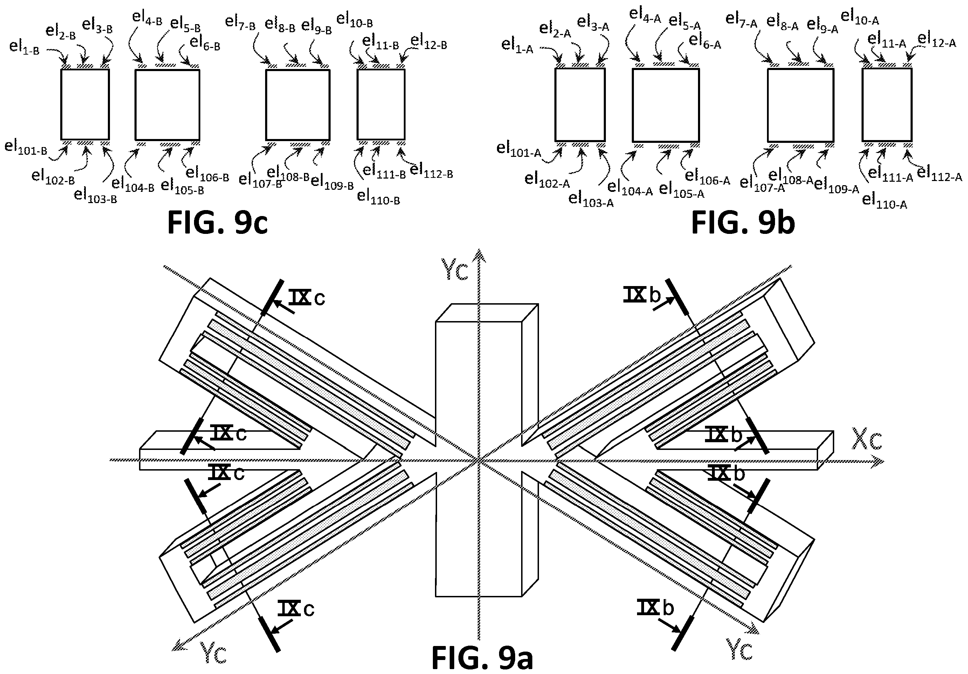

Pour équilibrer les forces et moments qui sont transmis à la partie de fixation Pf du résonateur, un nouveau gyromètre est proposé par l'invention, qui comprend deux portions vibrantes chacune similaire à celle de [Fig. 7a], orientées à l'opposé l'une de l'autre et avec un pied Pd qui leur est commun. Les deux portions vibrantes sont fabriquées dans la même plaquette, de sorte qu'elles sont continues de matériau à travers le pied Pd. Un tel gyromètre, qui est représenté dans [Fig. 8a]-[Fig. 8d] est efficace pour mesurer des rotations autour de l'axe X, ou autour de l'axe Y. Deux modes de vibration d'excitation sont possibles en tant que modes pilotes, qui préservent chacun l'équilibrage apporté par la structure en double-résonateur : un mode en opposition de phase, pour lequel les deux poutres P$_1$ et P$_2$ d'une des portions vibrantes s'écartent l'une de l'autre et se resserrent en opposition de phase par rapport aux poutres P$_3$ et P$_4$ de l'autre portion vibrante, comme représenté dans [Fig. 8a], et un mode en phase, pour lequel les deux poutres P$_1$ et P$_2$ d'une des portions vibrantes s'écartent l'une de l'autre et se resserrent en phase avec les poutres P$_3$ et P$_4$ de l'autre portion vibrante, comme représenté dans [Fig. 8c]. Dans ces deux figures, chaque inscription MV désigne la quantité de mouvement de la poutre ou du pédoncule à laquelle (auquel) elle est superposée. [Fig. 8b] montre l'équilibrage des forces d'inertie qui résultent des accélérations de Coriolis Γ$_C$ pour le mode de vibration d'excitation de [Fig. 8a] utilisé comme mode pilote, et [Fig. 8d] pour le mode de vibration d'excitation de [Fig. 8c] utilisé comme mode pilote. L'un ou l'autre de ces deux modes d'excitation est sélectionné comme mode pilote par la configuration des électrodes sur les deux portions vibrantes. Par exemple, dans le cas du cristal de quartz piézoélectrique ou de tout autre cristal piézoélectrique de la même classe de symétrie, le gyromètre peut être constitué de deux portions vibrantes tête-bêche, chacune à deux poutres faisant entre elles un angle de 60°, pour que ces poutres soient parallèles aux axes cristallographiques Yc+ et Yc-. [Fig. 9a]-[Fig. 9c] montrent un ensemble de rubans de matériau conducteur qui sont disposés sur les faces de tous les segments des deux portions vibrantes. Les deux portions vibrantes sont désignées par les lettres A et B, respectivement, et correspondent à la vue en coupe de [Fig. 9b] pour la portion vibrante A, et à la vue en coupe de [Fig. 9c] pour la portion vibrante B.

Pour un gyromètre dont l'axe sensible est l'axe X, parallèle à l'axe cristallographique Xc, le mode pilote est celui avec les deux résonateurs qui vibrent en opposition de phase, comme illustré par [Fig. 8a]. Il est alors possible d'appliquer l'enseignement de US 2012/0279303 A1 au nom du demandeur pour limiter les couplages capacitifs entre le mode pilote et le mode détecteur. Selon cet enseignement, les rubans $el_{3\text{-}A}$, $el_{103\text{-}A}$, $el_{4\text{-}A}$, $el_{104\text{-}A}$, $el_{9\text{-}A}$, $el_{109\text{-}A}$, $el_{10\text{-}A}$, $el_{110\text{-}A}$, $el_{3\text{-}B}$, $el_{108\text{-}B}$, $el_{4\text{-}B}$, $el_{104\text{-}B}$, $el_{9\text{-}B}$, $el_{110\text{-}B}$,$el_{110\text{-}B}$ permettent d'exciter le mode pilote en les connectant électriquement à une source de potentiel alternatif V, et en utilisant les rubans $el_{2\text{-}A}$, $el_{102\text{-}A}$, $el_{5\text{-}A}$, $el_{105\text{-}A}$, $el_{8\text{-}A}$, $el_{108\text{-}A}$, $el_{11\text{-}A}$ et $el_{111\text{-}A}$ pour détecter l'amplitude du mode pilote. Alors, les rubans $el_{1\text{-}A}$, $el_{101\text{-}A}$, $el_{6\text{-}A}$, $el_{106\text{-}A}$, $el_{7\text{-}A}$, $el_{107\text{-}A}$, $el_{12\text{-}A}$, $el_{112\text{-}A}$, $el_{1\text{-}B}$, $el_{101\text{-}B}$, $el_{6\text{-}B}$, $el_{106\text{-}B}$, $el_{7\text{-}B}$, $el_{107\text{-}B}$, $el_{12\text{-}B}$ peuvent être utilisés pour détecter les mouvements qui sont générés par une rotation autour de l'axe X, mais en connectant les rubans $el_{1\text{-}A}$, $el_{6\text{-}A}$, $el_{7\text{-}A}$, $el_{12\text{-}A}$, $el_{1\text{-}B}$, $el_{6\text{-}B}$, $el_{7\text{-}B}$ et $el_{12\text{-}B}$ d'une part, et les rubans $el_{101\text{-}A}$, $el_{106\text{-}A}$, $el_{107\text{-}A}$, $el_{112\text{-}A}$, $el_{101\text{-}B}$, $el_{106\text{-}B}$, $el_{107\text{-}B}$ et $el_{112\text{-}B}$ d'autre part, respectivement aux bornes d'entrée d'un amplificateur différentiel faisant partie d'un détecteur de courant électrique.

Pour un gyromètre dont l'axe sensible est l'axe Y, perpendiculaire à l'axe Xc du cristal et dans le plan commun des axes Xc, Yc+ et Yc-, le mode pilote est celui avec les deux résonateurs qui vibrent en phase, comme illustré par [Fig. 8c]. Les rubans $el_{1\text{-}A}$, $el_{101\text{-}A}$, $el_{6\text{-}A}$, $el_{106\text{-}A}$, $el_{7\text{-}A}$, $el_{107\text{-}A}$, $el_{12\text{-}A}$, $el_{112\text{-}A}$, $el_{1\text{-}B}$, $el_{101\text{-}B}$, $el_{6\text{-}B}$, $el_{106\text{-}B}$, $el_{7\text{-}B}$, $el_{107\text{-}B}$, $el_{12\text{-}B}$ et $el_{112\text{-}B}$ permettent alors d'exciter ce mode pilote en les reliant à la source de potentiel alternatif V, et en utilisant les rubans $el_{2\text{-}A}$, $el_{102\text{-}A}$, $el_{5\text{-}A}$, $el_{105\text{-}A}$, $el_{8\text{-}A}$, $el_{108\text{-}A}$, $el_{11\text{-}A}$, $el_{111\text{-}A}$, $el_{2\text{-}B}$, $el_{102\text{-}B}$, $el_{5\text{-}B}$, $el_{105\text{-}B}$, $el_{8\text{-}B}$, $el_{108\text{-}B}$, $el_{11\text{-}B}$ et $el_{111\text{-}B}$ pour détecter l'amplitude du mode pilote. Dans ce cas, les rubans $el_{3\text{-}A}$, $el_{103\text{-}A}$, $el_{4\text{-}A}$, $el_{104\text{-}A}$, $el_{9\text{-}A}$, $el_{109\text{-}A}$, $el_{10\text{-}A}$, $el_{110\text{-}A}$, $el_{3\text{-}B}$, $el_{103\text{-}B}$, $el_{4\text{-}B}$, $el_{104\text{-}B}$, $el_{9\text{-}B}$, $el_{109\text{-}B}$, $el_{10\text{-}B}$ et $el_{110\text{-}B}$ peuvent être utilisés pour détecter les mouvements qui sont générés par une rotation autour de l'axe Y, mais en connectant les rubans $el_{3\text{-}A}$, $el_{4\text{-}A}$, $el_{9\text{-}A}$, $el_{10\text{-}A}$, $el_{103\text{-}B}$, $el_{104\text{-}B}$, $el_{10\text{-}B}$ et $el_{110\text{-}B}$ d'une part, et les rubans $el_{103\text{-}A}$, $el_{104\text{-}A}$, $el_{109\text{-}A}$, $el_{110\text{-}A}$, $el_{3\text{-}B}$, $el_{4\text{-}B}$, $el_{9\text{-}B}$ et $el_{10\text{-}B}$ d'autre part, respectivement aux bornes d'entrée de l'amplificateur différentiel qui fait partie du détecteur de courant électrique.

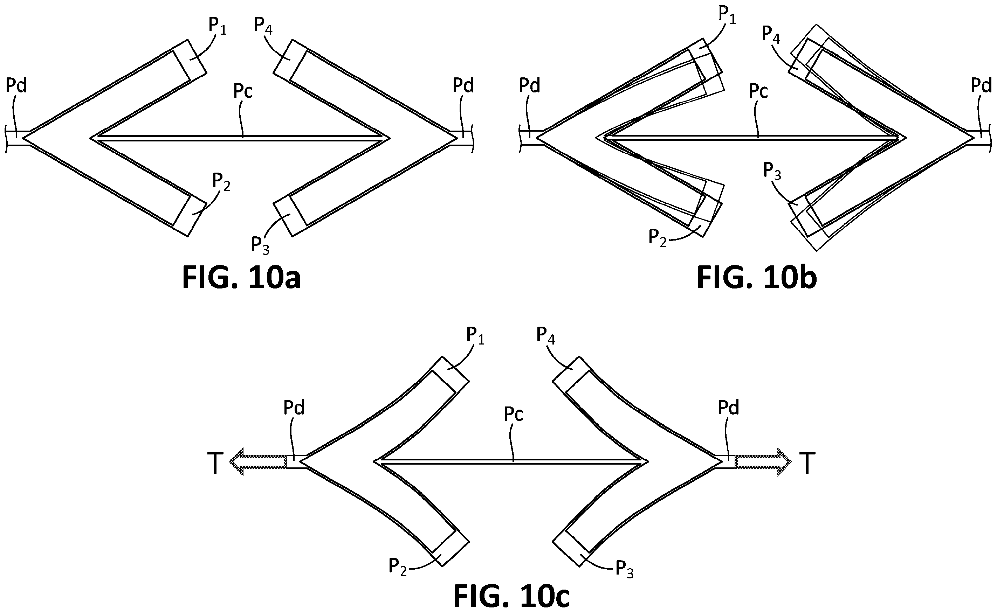

Une autre application de résonateurs conformes à l'invention est la réalisation d'un capteur de force. Le capteur de force, tel que montré dans [Fig. 10a], est basé sur deux portions vibrantes identiques qui sont encore réalisées dans une même plaquette, qui sont encore orientées à l'opposé l'une de l'autre mais solidaires par leurs pédoncules Pc. Chacune des deux portions vibrantes est dimensionnée pour être équilibrée individuellement. Les poutres $P_1$ et $P_2$ d'une des deux portions vibrantes d'une part, et celles $P_3$ et $P_4$ de l'autre portion vibrante d'autre part, forment entre elles des angles de 60°. Cette association des deux portions vibrantes permet d'obtenir un double-résonateur dont les deux extrémités, constituées par les pieds respectifs des portions vibrantes individuelles, sont exemptes ou quasi-exemptes de mouvement résiduel, comme montré par [Fig. 10b], pour un mode de vibration ou les deux portions vibrantes vibrent en opposition de phase. Lorsque ce capteur est soumis à une force de traction axiale, la déformation statique qui est imposée au double-résonateur modifie son inertie de flexion. [Fig. 10c] montre cette déformation statique pour la force de traction axiale T.

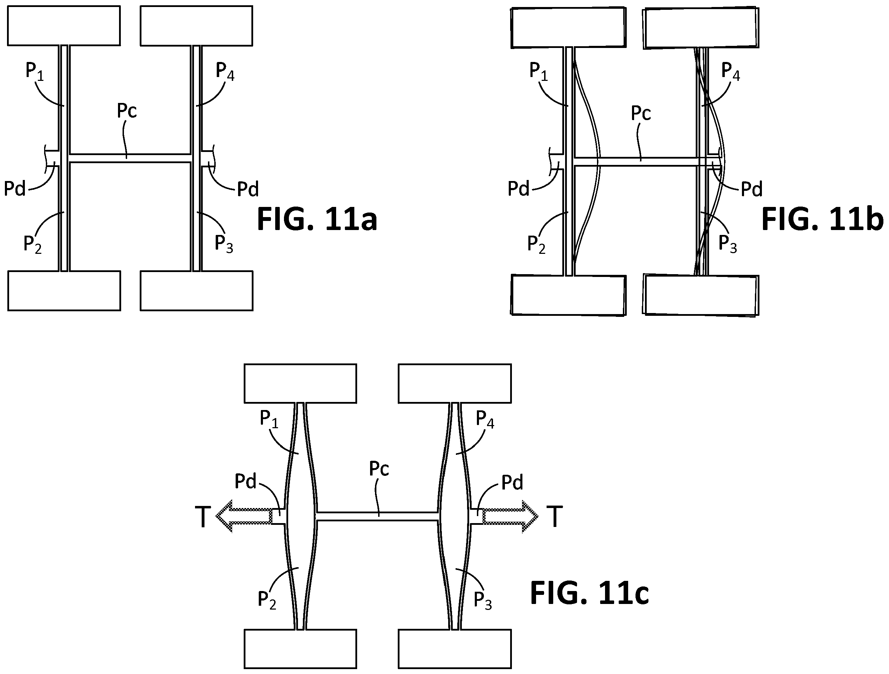

Si un tel capteur de force est réalisé en cristal de quartz, deux configurations sont possibles, qui correspondent soit à un angle $\alpha$ qui est égal à 60°, comme montré sur [Fig. 10a]-[Fig. 10c], soit à un angle $\alpha$ qui est égal à 180°, comme montré sur [Fig. 11a]-[Fig. 11c]. Ainsi, [Fig. 11a] montre la configuration à deux portions vibrantes pour lesquelles les poutres $P_1$ et $P_2$ d'une part, et $P_3$ et $P_4$ d'autre part, font un angle de 180° entre elles. [Fig. 11b] montre une déformation instantanée de la structure à double-résonateur de [Fig. 11a], pour le mode de vibration d'intérêt où les deux portions vibrantes vibrent en phase. [Fig. 11c] montre la déformation statique du même capteur de force lorsqu'il est soumis à la force de traction axiale T. Pour le cas où l'angle $\alpha$ est égal à 180°, la variation relative de fréquence F du mode de vibration considéré, induite par la force de traction axiale T, est proportionnelle à (équation 8) :

$$\frac{\Delta F}{F} \propto T \cdot \left[ \left( \frac{e_{int}}{L_{int}} \right)^3 + \left( \frac{e_{ext}}{L_{ext}} \right)^3 \right]$$

En utilisant l'équation 8, l'Homme du métier pourra dimensionner le capteur de force en fonction de chaque application et de la sensibilité de mesure qui est appropriée pour celle-ci.

Il est entendu que l'invention peut être reproduite en modifiant des aspects secondaires des modes de réalisation qui ont été décrits en détail ci-dessus, tout en conservant certains au moins des avantages cités. Notamment, le matériau de la plaquette n'est pas nécessairement un matériau monocristallin piézoélectrique. Par exemple, la plaquette peut être constituée de silicium, monocristallin ou polycristallin, ou bien être une céramique piézoélectrique, ou une combinaison d'un matériau métallique et de céramiques piézoélectriques. Les moyens d'excitation et de détection des vibrations doivent alors être adaptés en fonction de chaque matériau. Par exemple, l'excitation peut être réalisée en utilisant des forces électrostatiques, une force magnétique, ou en mettant en œuvre un effet photo-thermique, etc., et la détection peut être réalisée par mesure d'une variation de capacité d'un condensateur formé entre une partie du résonateur qui est en mouvement et une partie qui est fixe, ou en utilisant un effet piézo-résistif, ou en effectuant une mesure par interférométrie optique, etc. Enfin, toutes les valeurs numériques qui ont été citées ne l'ont été qu'à titre d'illustration, et peuvent être changées en fonction de l'application considérée.

**Revendications**

1. Résonateur comprenant :

   - une portion d'une plaquette à deux faces opposées qui sont planes et parallèles, la portion de plaquette étant destinée à vibrer par flexion lors d'une utilisation du résonateur, et appelée portion vibrante ; et
   - une partie de support (Pf), qui est externe à la portion vibrante et connectée à ladite portion vibrante par un segment intermédiaire de la plaquette, appelé pied (Pd), ledit pied étant continu de matériau avec la portion vibrante et formant une liaison rigide entre la partie de support et ladite portion vibrante,
   la portion vibrante ayant un premier plan de symétrie, appelé plan médian (M), qui est parallèle aux deux faces de la plaquette et équidistant avec lesdites deux faces, et un second plan de symétrie, appelé plan de symétrie orthogonal à la plaquette (P), qui est perpendiculaire au plan médian et passe longitudinalement par la liaison que forme le pied entre la partie de support (Pf) et la portion vibrante,
   une intersection entre le plan médian (M) et le plan de symétrie orthogonal à la plaquette (P) constituant un axe médian de la portion vibrante,
   la portion vibrante comprenant deux extensions ($P_1$, $P_2$) qui sont destinées chacune à vibrer par flexion, lesdites deux extensions s'étendant à partir du pied (Pd) symétriquement de chaque côté du plan de symétrie orthogonal à la plaquette (P),
   le résonateur étant **caractérisé en ce que** chaque extension ($P_1$, $P_2$) est pourvue d'une fente longitudinale ($FL_1$, $FL_2$) qui traverse la portion vibrante perpendiculairement au plan médian (M), à partir du plan de symétrie orthogonal à la plaquette (P) en direction d'une extrémité distale de ladite extension, mais sans atteindre ladite extrémité distale, de sorte que chaque extension soit formée par un méandre,
   les fentes ($FL_1$, $FL_2$) respectives des deux extensions ($P_1$, $P_2$) étant symétriques par rapport au plan de symétrie orthogonal à la plaquette (P), et se rejoignant au niveau dudit plan de symétrie orthogonal à la plaquette, de sorte que la portion vibrante comprenne deux segments primaires ($L_{1ext}$, $L_{2ext}$) qui relient chacun le pied (Pd) à l'extrémité distale de l'une des extensions, et deux segments secondaires ($L_{1int}$, $L_{2int}$) qui sont reliés l'un à l'autre au niveau du plan de symétrie orthogonal à la plaquette par des extrémités proximales respectives desdits segments secondaires, et qui s'étendent chacun jusqu'à l'extrémité distale de l'une des extensions pour être connectée à l'un des segments primaires au niveau de ladite extrémité distale,
   si bien que pour un mode de vibration de la partie vibrante qui ne comporte que des déplacements parallèles au plan médian (M), et qui est symétrique par rapport au plan de symétrie orthogonal à la plaquette (P), les deux segments primaires ($L_{1ext}$, $L_{2ext}$) ont des composantes de vitesse instantanées, parallèles à l'axe médian, qui ont un sens opposé à chaque instant pendant la vibration, à un sens de composantes de vitesse instantanées des segments secondaires ($L_{1int}$, $L_{2int}$), aussi parallèles à l'axe médian.

2. Résonateur selon la revendication 1, dans lequel la portion vibrante présente une répartition de masse telle que le mode de vibration qui ne comporte que des déplacements parallèles au plan médian (M) et qui est symétrique par rapport au plan de symétrie orthogonal à la plaquette (P), ne provoque pas de déplacement du pied (Pd) parallèlement à l'axe médian.

3. Résonateur selon la revendication 1 ou 2, dans lequel un matériau de la plaquette est monocristallin de classe trigonale et piézoélectrique, et dans lequel :

   l'axe médian de la portion vibrante est parallèle à un axe Xc dudit matériau, et
   les deux segments primaires ($L_{1ext}$, $L_{2ext}$) et les deux segments secondaires ($L_{1int}$, $L_{2int}$) de la portion vibrante sont parallèles à des axes Yc dudit matériau.

4. Résonateur selon la revendication 3, dans lequel les deux extensions ($P_1$, $P_2$) de la portion vibrante forment entre elles un angle ($\alpha$) qui est égal à 60° ou 180°.

5. Résonateur selon la revendication 3 ou 4, comprenant en outre :

- des moyens d'excitation, adaptés pour générer des déformations par flexion de la portion vibrante, lesdits moyens d'excitation comprenant une première et une seconde électrode isolées électriquement l'une de l'autre, ladite première électrode comprenant, sur chaque face de la plaquette et pour chaque segment primaire ($L_{1ext}$, $L_{2ext}$) ou secondaire ($L_{1int}$, $L_{2int}$), un ruban de matériau conducteur électriquement qui est disposé longitudinalement sur ledit segment, centralement dans une largeur dudit segment, et la seconde électrode comprenant, aussi sur chaque face de la plaquette et pour chaque segment primaire ou secondaire, deux rubans sur ledit segment qui sont disposés sur deux côtés opposés du ruban de la première électrode ; et
- des moyens de détection, adaptés pour mesurer une amplitude de déformations de flexion la partie vibrante qui sont générées par les moyens d'excitation lors d'une utilisation du résonateur, lesdits moyens de détection comprenant un circuit de détection d'un courant électrique qui apparaît dans les première et seconde électrodes.

6. Résonateur selon l'une quelconque des revendications précédentes, dans lequel chaque extension ($P_1$, $P_2$) comporte, au niveau de son extrémité distale et parallèlement au plan médian (M), un élargissement par rapport à des bords longitudinaux externes des segments primaire ($L_{1ext}$, $L_{2ext}$) et secondaire ($L_{1int}$, $L_{2int}$) de ladite extension.

7. Résonateur selon l'une quelconque des revendications précédentes, comprenant en outre une portion supplémentaire de la plaquette, en forme de segment et appelée pédoncule (Pc), qui s'étend à partir des extrémités proximales des segments secondaires ($L_{1int}$, $L_{2int}$) reliées l'une à l'autre, parallèlement à l'axe médian et dans une direction opposée au pied (Pd).

8. Résonateur selon la revendication 7, comprenant deux portions vibrantes formées dans la même plaquette, munies de pédoncules (Pd) respectifs, lesdites deux portions vibrantes étant reliées l'une à l'autre par lesdits pédoncules, et orientées de façon opposée l'une par rapport à l'autre de sorte que les axes médians respectifs desdites deux portions vibrantes soient superposés.

9. Résonateur selon l'une quelconque des revendications 1 à 7, comprenant deux portions vibrantes formées dans la même plaquette, les deux portions vibrantes étant reliées l'une à l'autre par les pieds (Pd) respectifs desdites deux portions vibrantes, et orientées de façon opposée l'une par rapport à l'autre de sorte que les axes médians respectifs desdites deux portions vibrantes soient superposés.

10. Capteur de force, comprenant un résonateur conforme à la revendication 8, et adapté pour mesurer une force de traction appliquée entre les pieds (Pd) respectifs des deux portions vibrantes, et parallèle aux axes médians desdites deux portions vibrantes.

11. Gyromètre, comprenant au moins un résonateur conforme à l'une quelconque des revendications 1 à 9.

**Patentansprüche**

1. Resonator umfassend:

- einen als vibrierenden Abschnitt bezeichneten Abschnitt einer Platte mit zwei gegenüberliegenden Flächen, die eben und parallel sind, wobei der Plattenabschnitt dazu bestimmt ist, bei einer Verwendung des Resonators durch Biegung zu vibrieren, und
- ein Trägerteil (Pf), das außerhalb des vibrierenden Abschnitts liegt und mit dem vibrierenden Abschnitt durch ein als Fuß (Pd) bezeichnetes Zwischensegment der Platte verbunden ist, wobei der Fuß mit dem vibrierenden Abschnitt materialmäßig durchgängig ist und eine starre Verbindung zwischen dem Trägerteil und dem vibrierenden Abschnitt ausbildet,

wobei der vibrierende Abschnitt eine als Mittelebene (M) bezeichnete erste Symmetrieebene, die parallel zu den zwei Flächen der Platte und gleichbeabstandet zu den zwei Flächen ist, und eine als zu der Platte (P) orthogonale Symmetrieebene bezeichnete zweite Symmetrieebene aufweist, die senkrecht zu der Mittelebene ist und in Längsrichtung durch die Verbindung verläuft, die der Fuß zwischen dem Trägerteil (Pf) und dem vibrierenden Abschnitt ausbildet,
einen Schnittpunkt zwischen der Mittelebene (M) und der zu der Platte (P) orthogonalen Symmetrieebene, der eine Mittelachse des vibrierenden Abschnitts darstellt,

wobei der vibrierende Abschnitt zwei Verlängerungen ($P_1$, $P_2$) umfasst, die jeweils dazu bestimmt sind, durch Biegung zu vibrieren, wobei sich die zwei Verlängerungen ausgehend von dem Fuß (Pd) symmetrisch auf jeder Seite der zu der Platte (P) orthogonalen Symmetrieebene erstrecken,

wobei der Resonator **dadurch gekennzeichnet ist, dass** jede Verlängerung ($P_1$, $P_2$) mit einem Längsschlitz ($FL_1$, $FL_2$) versehen ist, der entlang des vibrierenden Abschnitts senkrecht zu der Mittelebene (M) ausgehend von der zu der Platte (P) orthogonalen Symmetrieebene in Richtung eines distalen Endes der Verlängerung, aber ohne das distale Ende zu erreichen, verläuft, sodass jede Verlängerung durch eine Windung gebildet wird,

wobei die jeweiligen Schlitze ($FL_1$, $FL_2$) der zwei Verlängerungen ($P_1$, $P_2$) relativ zu der zu der Platte (P) orthogonalen Symmetrieebene symmetrisch sind und sich an der zu der Platte orthogonalen Symmetrieebene treffen, sodass der vibrierende Abschnitt zwei Primärsegmente ($L_{1ext}$, $L_{2ext}$), die den Fuß (Pd) jeweils mit dem distalen Ende einer der Verlängerungen verbinden, und zwei Sekundärsegmente ($L_{1int}$, $L_{2int}$) umfasst, die an der zu der Platte orthogonalen Symmetrieebene durch jeweilige proximale Enden der Sekundärsegmente miteinander verbunden sind und die sich jeweils bis zu dem distalen Ende einer der Verlängerungen erstrecken, sodass sie an einem der Primärsegmente an dem distalen Ende verbunden sind,

sodass für einen Vibrationsmodus des vibrierenden Teils, der ausschließlich zu der Mittelebene (M) parallele Verschiebungen vorweist und bezüglich der zu der Platte (P) orthogonalen Symmetrieebene symmetrisch ist, die zwei Primärsegmente ($L_{1ext}$, $L_{2ext}$) zu der Mittelachse parallele momentane Geschwindigkeitskomponenten aufweisen, die zu jedem Zeitpunkt während der Vibration eine entgegengesetzte Richtung zu der Richtung der momentanen Geschwindigkeitskomponenten der Sekundärsegmente ($L_{1int}$, $L_{2int}$), die ebenfalls zu der Mittelachse parallel sind, aufweisen.

2. Resonator nach Anspruch 1, wobei der vibrierende Abschnitt eine derartige Massenverteilung aufweist, dass der Vibrationsmodus, der ausschließlich zu der Mittelebene (M) parallele Verschiebungen vorweist und der bezüglich der zu der Platte (P) orthogonalen Symmetrieebene symmetrisch ist, keine Verschiebung des Fußes (Pd) parallel zu der Mittelachse verursacht.

3. Resonator nach Anspruch 1 oder 2, wobei ein Material der Platte monokristallin der trigonalen Klasse und piezoelektrisch ist und wobei: die Mittelachse des vibrierenden Abschnitts parallel zu einer Achse Xc des Materials ist, und die zwei Primärsegmente ($L_{1ext}$, $L_{2ext}$) und die zwei Sekundärsegmente ($L_{1int}$, $L_{2int}$) des vibrierenden Abschnitts parallel zu den Achsen Yc des Materials sind.

4. Resonator nach Anspruch 3, wobei die zwei Verlängerungen ($P_1$, $P_2$) des vibrierenden Abschnitts untereinander einen Winkel ($\alpha$) bilden, der gleich 60° oder 180° ist.

5. Resonator nach Anspruch 3 oder 4, ferner umfassend:

- Anregungsmittel, die zum Erzeugen von Verformungen durch Biegung des vibrierenden Abschnitts angepasst sind, wobei die Anregungsmittel eine erste und eine zweite elektrisch voneinander isolierte Elektrode umfassen, wobei die erste Elektrode auf jeder Seite der Platte und für jedes Primärsegment ($L_{1ext}$, $L_{2ext}$) oder Sekundärsegment ($L_{1int}$, $L_{2int}$) ein Band aus elektrisch leitendem Material umfasst, das in Längsrichtung auf dem Segment mittig einer Breite des Segments angeordnet ist, und wobei die zweite Elektrode ebenfalls auf jeder Seite der Platte und für jedes Primär- oder Sekundärsegment zwei Bänder auf dem Segment umfasst, die auf zwei gegenüberliegenden Seiten des Bandes der ersten Elektrode angeordnet sind; und
- Erfassungsmittel, die zum Messen einer Amplitude von Biegeverformungen des vibrierenden Teils angepasst sind, die durch die Anregungsmittel während der Verwendung des Resonators erzeugt werden, wobei die Erfassungsmittel eine Schaltung zum Erfassen eines elektrischen Stroms, der in der ersten und der zweiten Elektrode auftritt, umfassen.

6. Resonator nach einem der vorstehenden Ansprüche, wobei jede Verlängerung ($P_1$, $P_2$) an ihrem distalen Ende und parallel zu der Mittelebene (M) eine Ausweitung relativ zu den äußeren Längskanten der Primärsegmente ($L_{1ext}$, $L_{2ext}$) und der Sekundärsegmente ($L_{1int}$, $L_{2int}$) der Verlängerung vorweist.

7. Resonator nach einem der vorstehenden Ansprüche, ferner umfassend einen als Stiel (Pc) bezeichneten zusätzlichen Abschnitt der Platte in Form eines Segments, der sich von den miteinander verbundenen proximalen Enden der Sekundärsegmente ($L_{1int}$, $L_{2int}$) parallel zu der Mittelachse und in entgegengesetzter Richtung zu dem Fuß (Pd) erstreckt,

**8.** Resonator nach Anspruch 7, umfassend zwei vibrierende Abschnitte, die in derselben Platte ausgebildet sind, die mit jeweiligen Stielen (Pd) ausgestattet sind, wobei die zwei vibrierenden Abschnitte durch die Stiele miteinander verbunden und auf zueinander entgegengesetzte Weise ausgerichtet sind, sodass die jeweiligen Mittelachsen der zwei vibrierenden Abschnitte übereinander liegen.

**9.** Resonator nach einem der Ansprüche 1 bis 7, umfassend zwei vibrierende Abschnitte, die in derselben Platte ausgebildet sind, wobei die zwei vibrierenden Abschnitte durch die jeweiligen Füße (Pd) der zwei vibrierenden Abschnitte miteinander verbunden und auf zueinander entgegengesetzte Weise ausgerichtet sind, sodass die jeweiligen Mittelachsen der zwei vibrierenden Abschnitte übereinander liegen.

**10.** Kraftsensor, umfassend einen Resonator nach Anspruch 8, und der zum Messen einer Zugkraft angepasst ist, die zwischen den jeweiligen Füßen (Pd) der zwei vibrierenden Abschnitte und parallel zu den Mittelachsen der zwei vibrierenden Abschnitte ausgeübt wird.

**11.** Gyrometer, umfassend mindestens einen Resonator nach einem der Ansprüche 1 bis 9.

**Claims**

**1.** A resonator comprising:

- a portion of a wafer having two opposite faces which are flat and parallel, the wafer portion being intended to vibrate flexurally during use of the resonator, and referred to as the vibrating portion; and
- a support part (Pf), which is external to the vibrating portion and connected thereto by an intermediate segment of the wafer referred to as a foot (Pd), said foot being integral with the vibrating portion and forming a rigid connection between the support part and said vibrating portion,
the vibrating portion having a first plane of symmetry, referred to as the midplane (M), which is parallel to both faces of the wafer and equidistant from said two faces, and a second plane of symmetry, referred to as the plane of symmetry orthogonal to the wafer (P), which is perpendicular to the midplane and which passes longitudinally through the connection formed by the foot between the support part (Pf) and the vibrating portion,
an intersection between the midplane (M) and the plane of symmetry orthogonal to the wafer (P) constituting a center axis of the vibrating portion,
the vibrating portion comprising two extensions ($P_1$, $P_2$) which are each intended to vibrate flexurally, said two extensions extending symmetrically from the foot (Pd) on each side of the plane of symmetry orthogonal to the wafer (P),
the resonator being **characterized in that** each extension ($P_1$, $P_2$) is provided with a longitudinal slot ($FL_1$, $FL_2$) which passes through the vibrating portion perpendicularly to the midplane (M), from the plane of symmetry orthogonal to the wafer (P) towards a distal end of said extension but without reaching said distal end, so that each extension is meander shaped,
the respective slots ($FL_1$, $FL_2$) of the two extensions ($P_1$, $P_2$) being symmetrical relative to the plane of symmetry orthogonal to the wafer (P), and meeting at said plane of symmetry orthogonal to the wafer, so that the vibrating portion comprises two primary segments ($L_{1ext}$, $L_{2ext}$) which each connect the foot (Pd) to the distal end of one of the extensions, and two secondary segments ($L_{1int}$, $L_{2int}$) which are interconnected at the plane of symmetry orthogonal to the wafer by respective proximal ends of said secondary segments, and which each extend to the distal end of one of the extensions so as to connect to one of the primary segments at said distal end,
such that for a mode of vibration of the vibrating portion which comprises only movements parallel to the midplane (M), and which is symmetrical relative to the plane of symmetry orthogonal to the wafer (P), both primary segments ($L_{1ext}$, $L_{2ext}$) have instantaneous velocity components, parallel to the center axis, which at each instant during vibration, are in the opposite direction to that of instantaneous velocity components of the secondary segments ($L_{1int}$, $L_{2int}$), also parallel to the center axis.

**2.** The resonator according to claim 1, wherein the vibrating portion has a distribution of mass such that the mode of vibration, which only comprises movements parallel to the midplane (M) and which is symmetrical relative to the plane of symmetry orthogonal to the wafer (P), does not cause movement of the foot (Pd) parallel to the center axis.

**3.** The resonator according to claim 1 or 2, wherein a material of the wafer is monocrystalline and of trigonal class and piezoelectric, and wherein:

the center axis of the vibrating portion is parallel to an axis Xc of said material, and
both primary segments ($L_{1ext}$, $L_{2ext}$) as well as both secondary segments ($L_{1int}$, $L_{2int}$) of the vibrating portion are parallel to axes Yc of said material.

4. The resonator according to claim 3, wherein both extensions ($P_1$, $P_2$ of the vibrating portion form an angle ($\alpha$) between them which is equal to 60° or 180°.

5. The resonator according to claim 3 or 4, further comprising:

   - excitation means, adapted for generating flexural deformations of the vibrating portion, said excitation means comprising first and second electrodes which are electrically insulated from each other, said first electrode comprising, on each face of the wafer and for each primary ($L_{1ext}$, $L_{2ext}$) or secondary ($L_{1int}$, $L_{2int}$) segment, a strip of electrically conducting material which is arranged longitudinally on said segment, centrally within a width of said segment, and the second electrode comprising, also on each face of the wafer and for each primary or secondary segment, two strips on said segment which are arranged on two opposite sides of the strip of the first electrode; and
   - detection means, adapted for measuring an amplitude of flexural deformations of the vibrating portion which are generated by the excitation means during use of the resonator, said detection means comprising a circuit for detecting an electrical current which appears in the first and second electrodes.

6. The resonator according to any one of the preceding claims, wherein each extension ($P_1$, $P_2$) comprises, at its distal end and parallel to the midplane (M), a widening relative to the outer longitudinal edges of the primary ($L_{1ext}$, $L_{2ext}$) and secondary ($L_{1int}$, $L_{2int}$) segments of said extension.

7. The resonator according to any one of the preceding claims, further comprising an additional portion of the wafer, in the form of a segment and referred to as a stem (Pc), which extends from the interconnected proximal ends of the secondary segments ($L_{1int}$, $L_{2int}$), parallel to the center axis and in a direction away from the foot (Pd).

8. The resonator according to claim 7, comprising two vibrating portions formed in the same wafer, provided with respective stems (Pd), said two vibrating portions being interconnected by said stems, and oriented opposite to each other so that the respective center axes of said two vibrating portions are superimposed.

9. The resonator according to any one of claims 1 to 7, comprising two vibrating portions formed in the same wafer, both vibrating portions being interconnected by the respective feet (Pd) of said two vibrating portions, and oriented opposite to each other so that the respective center axes of said two vibrating portions are superimposed.

10. A force sensor, comprising a resonator according to claim 8, and adapted for measuring a tensile force which is applied between the respective feet (Pd) of both vibrating portions and which is parallel to the center axes of said two vibrating portions.

11. A rate gyro, comprising at least one resonator according to any one of claims 1 to 9.

FIG. 1b

FIG. 1a

**FIG. 2b**

**FIG. 2a**

FIG. 3c

FIG. 3b

FIG. 3a

**FIG. 4d**

**FIG. 4c**

**FIG. 4a**

**FIG. 4b**

EP 4 305 752 B1

FIG. 5b

FIG. 5a

FIG. 6a     FIG. 6b     FIG. 6c     FIG. 6d

EP 4 305 752 B1

**FIG. 7a**

**FIG. 7b**

**FIG. 7c**

**FIG. 7d**

EP 4 305 752 B1

FIG. 8a

FIG. 8c

FIG. 8b

FIG. 8d

EP 4 305 752 B1

EP 4 305 752 B1

$el_{1-B}$ $el_{2-B}$ $el_{3-B}$ $el_{4-B}$ $el_{5-B}$ $el_{6-B}$ $el_{7-B}$ $el_{8-B}$ $el_{9-B}$ $el_{10-B}$ $el_{11-B}$ $el_{12-B}$

$el_{101-B}$ $el_{102-B}$ $el_{103-B}$ $el_{104-B}$ $el_{105-B}$ $el_{106-B}$ $el_{107-B}$ $el_{108-B}$ $el_{109-B}$ $el_{110-B}$ $el_{111-B}$ $el_{112-B}$

**FIG. 9c**

$el_{1-A}$ $el_{2-A}$ $el_{3-A}$ $el_{4-A}$ $el_{5-A}$ $el_{6-A}$ $el_{7-A}$ $el_{8-A}$ $el_{9-A}$ $el_{10-A}$ $el_{11-A}$ $el_{12-A}$

$el_{101-A}$ $el_{102-A}$ $el_{103-A}$ $el_{104-A}$ $el_{105-A}$ $el_{106-A}$ $el_{107-A}$ $el_{108-A}$ $el_{109-A}$ $el_{110-A}$ $el_{111-A}$ $el_{112-A}$

**FIG. 9b**

Yc
Xc
Yc
Yc

IXc    IXb

**FIG. 9a**

FIG. 10a

FIG. 10b

FIG. 10c

EP 4 305 752 B1

FIG. 11a

FIG. 11b

FIG. 11c

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 3683213 A
- US 4215570 A
- US 6414416 B1
- US 4524619 A
- FR 2944102 A1
- US 20060201248 A1
- FR 2574209 A1
- FR 2739190 A1
- FR 2805344 A1
- US 20120279303 A1

**Littérature non-brevet citée dans la description**

- **GUÉRARD et al.** *Quartz structures for Coriolis Vibrating Gyroscopes*
- **Y. OMURA** ; **Y. NONOMURA** ; **O. TABATA**. New resonant accelerometer based on rigidity change. *TRANSDUCERS*, 1997, vol. 97
- **C. ZENER**. Internal friction in solids. *Physical Review*, August 1937, vol. 52, 230-235